# EUROPEAN PATENT APPLICATION

(11) **EP 4 611 239 A1**
(43) Date of publication of application: **03.09.2025**
(21) Application number: 22963542.0
(22) Date of filing: 28.10.2022
(51) Int. Cl.: H02M 1/08

(54) **GATE DRIVING DEVICE OF SEMICONDUCTOR ELEMENT FOR ELECTRIC POWER, AND ELECTRIC POWER CONVERSION DEVICE**

(71) Applicant: MITSUBISHI ELECTRIC CORPORATION, Chiyoda-ku Tokyo 100-8310 (JP)
(72) Inventor: URAKABE, Takahiro, Tokyo 152-8550 (JP); HAGIWARA, Makoto, Tokyo 152-8550 (JP); HIGAKI, Yusuke, Tokyo 100-8310 (JP)
(74) Representative: Hoffmann Eitle
(86) International application number: PCT/JP2022/040527
(87) International publication number: WO 2024/089896

(57) **Abstract**

A gate drive device comprises: a gate drive voltage output unit provided for each of a plurality of series-connected power semiconductor devices to output a gate drive voltage; a gate line provided for each gate drive voltage output unit and connected to a control terminal of the power semiconductor device associated with the gate drive voltage output unit; a magnetic coupling unit to magnetically couple the gate line and another such gate line together; a first wiring route to pass a current from the gate drive voltage output unit toward the gate line associated with the gate drive voltage output unit; a second wiring route to pass a current from the gate line connected to the first wiring route toward the gate drive voltage output unit associated with the gate line; and a third wiring route to attenuate an exciting current generated in the magnetic coupling unit.

## Description

### TECHNICAL FIELD

The present disclosure relates to a gate drive device for a power semiconductor device, and a power conversion apparatus.

### BACKGROUND ART

A variety of types of gate drive devices have been proposed to turn on and off each of semiconductor switching elements that are a plurality of series-connected power semiconductor devices.

For example, a known control device for series-connected voltage-driven semiconductor devices comprises a semiconductor switch circuit composed of a plurality of voltage-driven semiconductor devices connected in series and constituting an arm and a gate drive circuit to supply a gate signal to a gate terminal of each of the voltage-driven semiconductor devices in each arm, characterized in that gate lines interconnecting the gate drive circuit and the gate terminals of the voltage-driven semiconductor devices in each arm are magnetically coupled together (See PTL 1 for example).

For example, a known control device for series-connected voltage-driven semiconductor devices comprises a semiconductor switch circuit composed of a plurality of series-connected voltage-driven semiconductor devices and a gate drive circuit to supply a gate signal to the gate terminals of the voltage-driven semiconductor devices to turn on/off the voltage-driven semiconductor devices, characterized in that a winding for magnetically coupling together gate lines interconnecting the gate drive circuit and the gate terminals of the voltage-driven semiconductor devices and a resetting winding are provided, and excitation energy stored based on the magnetic coupling is reset via the resetting winding (See PTL 2 for example.).

### CITATION LIST

### PATENT LITERATURE

PTL 1: Japanese Patent 4396036
PTL 2: Japanese Patent 4396059

### SUMMARY OF INVENTION

### TECHNICAL PROBLEM

For example, in the invention described in PTL 1 (Japanese Patent No. 4396036), the gate lines respectively for the voltage-driven semiconductor devices are magnetically coupled together, and when currents flowing through the gate lines have different values at the time of turning on or off of the voltage-driven semiconductor devices, the gate lines are instantaneously changed in impedance depending on the difference to match each gate current to one another to suppress variation in timing of switching. However, in the invention described in PTL 1 (Japanese Patent No. 4396036), when each series-connected power semiconductor device is turned on and off, it has a gate-source voltage periodically oscillating with a different phase for some condition. When a subsequent switching operation is performed for the power semiconductor device before the oscillation is attenuated, there is a difference in gate voltage at a time point when the switching starts, and this increases unbalance in voltage sharing (or unbalance in drain-source voltage) for each series-connected power semiconductor device.

Therefore, for a gate drive device for a plurality of series connected power semiconductor devices and a power conversion apparatus comprising the same, there is a demand for a technique so that even if a gate signal is transmitted for varying periods of time or the power semiconductor devices have varying characteristics, oscillation of a current flowing through the gate terminal of each power semiconductor device, and hence unbalance in voltage sharing for each power semiconductor device when a switching operation is performed, are suppressed.

### SOLUTION TO PROBLEM

According to one aspect of the present disclosure, a gate drive device for a plurality of series-connected power semiconductor devices comprises: a gate drive voltage output unit provided for each of the power semiconductor devices to output a gate drive voltage; a gate line provided for each gate drive voltage output unit and connected to a control terminal of the power semiconductor device associated with the gate drive voltage output unit; a magnetic coupling unit to magnetically couple the gate line and another such gate line together; a first wiring route serving as a path for a current flowing from the gate drive voltage output unit toward the gate line associated with the gate drive voltage output unit; a second wiring route serving as a path for a current flowing from the gate line connected to the first wiring route toward the gate drive voltage output unit associated with the gate line; and a third wiring route to attenuate an exciting current generated in the magnetic coupling unit.

Herein, the first wiring route may include a first diode having an anode connected to a wire leading to a positive terminal of the gate drive voltage output unit and a cathode connected to a wire leading to the magnetic coupling unit, and the second wiring route may include a second diode having a cathode connected to a wire leading to a negative terminal of the gate drive voltage output unit and an anode connected to a wire leading to the magnetic coupling unit.

Furthermore, the third wiring route may include a first resistor connected to the first diode in parallel and a second resistor connected to the second diode in parallel.

Furthermore, the third wiring route may include a series circuit including a third resistor and a first switch to open and close to connect and disconnect a wire leading to the third resistor, and the series circuit may be connected to one of the two gate lines that are magnetically coupled together by the magnetic coupling unit such that the series circuit is in parallel with the magnetic coupling unit.

Furthermore, the first switch may be adapted to turn on for a first determined period of time of a period of time for which the first wiring route passes a current and turn off for a period of time excluding the first determined period of time, and turn on for a second determined period of time of a period of time for which the second wiring route passes a current and turn off for a period of time excluding the second determined period of time.

Furthermore, the first wiring route may include a positive switch to apply to the control terminal of the power semiconductor device associated with the first wiring route or interrupt a potential on a side of a positive electrode of the gate drive voltage output unit, and a positive gate resistance connected to the positive switch in series, and the second wiring route may include a negative switch to apply to the control terminal of the power semiconductor device associated with the second wiring route or interrupt a potential on a side of a negative electrode of the gate drive voltage output unit, the potential being 0 volt or less, and a negative gate resistance connected to the negative switch in series.

Furthermore, each gate drive voltage output unit may include a positive potential output unit to output a positive potential of the gate drive voltage, and a negative potential output unit connected to the positive potential output unit in series to output a negative potential of the gate drive voltage, and the third wiring route may include a second switch to open and close to connect and disconnect a wire between the control terminal of the power semiconductor device and a connection point between the positive switch and the side of the positive electrode of the positive potential output unit, and a third switch to open and close to connect and disconnect a wire between the control terminal of the power semiconductor device and a connection point between the negative switch and the side of the negative electrode of the negative potential output unit.

Furthermore, the second switch may be adapted to turn on while the positive switch turns on, and thereafter, turn off before turning on the negative switch starts, and the third switch may be adapted to turn on while the negative switch turns on, and thereafter, turn off before turning on the positive switch starts.

Furthermore, the power semiconductor device has a current outflow terminal, which may be a source terminal, an emitter terminal, or a cathode terminal.

Furthermore, according to one aspect of the present disclosure, a gate drive device for a plurality of series-connected power semiconductor devices comprises: a gate drive voltage output unit provided for each of the power semiconductor devices to output a gate drive voltage; a gate line provided for each gate drive voltage output unit and connected to a control terminal of the power semiconductor device associated with the gate drive voltage output unit; a magnetic coupling unit to magnetically couple the gate line and another such gate line together; a fourth wiring route serving as a path for a current flowing from the gate drive voltage output unit toward the gate line associated with the gate drive voltage output unit; a fifth wiring route serving as a path for a current flowing from the control terminal of the power semiconductor device to which the gate line is connected toward the gate drive voltage output unit associated with the gate line; and a sixth wiring route to attenuate an exciting current generated in the magnetic coupling unit.

Herein, the fourth wiring route may include a fourth diode having an anode connected to a wire leading to a positive terminal of the gate drive voltage output unit and a cathode connected to a wire leading to the magnetic coupling unit, and the sixth wiring route may include a fourth resistor connected to the fourth diode in parallel.

Furthermore, the control terminal of the power semiconductor device may be a gate terminal or a base terminal.

Furthermore, according to one aspect of the present disclosure, a power conversion apparatus comprises: the gate drive device described above; a power conversion circuit unit having an arm provided with the plurality of series-connected power semiconductor devices to perform a power conversion operation in response to the power semiconductor devices turning on/off; and a power conversion control unit to control the power conversion operation of the power conversion circuit unit.

### ADVANTAGEOUS EFFECTS OF INVENTION

According to one aspect of the present disclosure, a gate drive device for a plurality of series-connected power semiconductor devices and a power conversion apparatus comprising the same, even with a gate signal transmitted for varying periods of time or the power semiconductor devices having varying characteristics, can suppress oscillation of a current flowing through a control terminal of each power semiconductor device, and hence unbalance in voltage sharing for each power semiconductor device when a switching operation is performed.

### BRIEF DESCRIPTION OF DRAWINGS

Fig. 1 is a circuit diagram of a gate drive device according to a first embodiment of the present disclosure.
Fig. 2 is a diagram for exemplarily illustrating a magnetic coupling unit in the gate drive device according to the first to fourth embodiments of the present disclosure.
Fig. 3 is a circuit diagram (part 1) for illustrating how a current flows in the gate drive device when a power semiconductor device Q_{A} turns on according to the first embodiment of the present disclosure.
Fig. 4 is a circuit diagram (part 2) for illustrating how a current flows in the gate drive device when power semiconductor device Q_{A} turns on according to the first embodiment of the present disclosure.
Fig. 5 is a diagram showing a power conversion apparatus comprising a gate drive device according to one embodiment of the present disclosure.
Fig. 6 is a circuit diagram of an arm provided in the power conversion apparatus shown in Fig. 5.
Fig. 7 is a circuit diagram of a gate drive device based on the invention described in PTL 1 (Japanese Patent No. 4396036).
Fig. 8 is a diagram for exemplarily illustrating a waveform of a gate-source voltage of each power semiconductor device when a transition is made from an off state to an on state while a gate signal is shifted and thus transmitted in the invention based on PTL 1 (Japanese Patent No. 4396036).
Fig. 9 is a diagram for exemplarily illustrating drain-source voltages of power semiconductor devices Q_{A} and Q_{B} and a current flowing from the drain to the source when power semiconductor devices Q_{A} and Q_{B} transition from an on state to an off state while voltage sharing is unbalanced in the invention based on PTL 1 (Japanese Patent No. 4396036).
Fig. 10 is a diagram for exemplarily illustrating drain-source voltages of power semiconductor devices Q_{A} and Q_{B} and a drain current flowing from the drain to the source when power semiconductor devices Q_{A} and Q_{B} transition from the off state to the on state while voltage sharing is unbalanced in the invention based on PTL 1 (Japanese Patent No. 4396036).
Fig. 11 is an equivalent circuit diagram showing how a current flows in the invention based on PTL 1 (Japanese Patent No. 4396036) when a transition is made from the off state to the on state while a gate signal is shifted and thus transmitted.
Fig. 12 is an equivalent circuit diagram showing how a current flows in the invention based on PTL 1 (Japanese Patent No. 4396036) when a power semiconductor device transitions from the off state to the on state while the gate signal is transmitted without being shifted.
Fig. 13 is a diagram representing a simulation of gate-source voltage in waveform in the invention based on PTL 1 (Japanese Patent No. 4396036).
Fig. 14 is a diagram representing a simulation of gate-source voltage in waveform in the gate drive device according to the first embodiment of the present disclosure.
Fig. 15 is a circuit diagram of a gate drive device according to a second embodiment of the present disclosure.
Fig. 16 is a circuit diagram of a gate drive device according to a third embodiment of the present disclosure.
Fig. 17 is a diagram representing a simulation of gate-source voltage in waveform in the gate drive device according to the third embodiment of the present disclosure.
Fig. 18 is a diagram for illustrating how a first switch, a positive switch, and a negative switch operate in the gate drive device according to the third embodiment of the present disclosure.
Fig. 19 is a circuit diagram of a gate drive device according to a fourth embodiment of the present disclosure.
Fig. 20 is a diagram for illustrating how each switch operates in the gate drive device according to the fourth embodiment of the present disclosure.

### DESCRIPTION OF EMBODIMENTS

Hereinafter, a gate drive device for a power semiconductor device and a power conversion apparatus will be described with reference to the drawings. In the drawings, identical or similar components are identically denoted. In order to facilitate understanding, the drawings are not to scale. The illustrated embodiments are merely examples for implementation, rather than limitation. Throughout the specification, when a switch is "on," it means that an electric path provided with the switch is closed, that is, when the switch turns on, the electric path provided with the switch is connected and thus closed. Further, when a switch is "off," it means that an electric path provided with the switch opens, that is, when the switch turns off, the electric path provided with the switch is disconnected and thus opened.

A gate drive device according to each embodiment of the present disclosure drives a plurality of series-connected power semiconductor devices on and off. Examples of the power semiconductor device include a MOSFET, an IGBT, a thyristor, a GTO, and a transistor. The MOSFET has a gate terminal, a drain terminal, and a source terminal as its terminals. The IGBT has a gate terminal, a collector terminal, and an emitter terminal as its terminals. The transistor has a base terminal, a collector terminal, and an emitter terminal as its terminals. The thyristor and the GTO have a gate terminal, an anode terminal, and a cathode terminal as their terminals. A "current inflow terminal" of the power semiconductor device corresponds to the "drain terminal" of the MOSFET, the "collector terminal" of the IGBT and the transistor, and the "anode terminal" of the thyristor and the GTO. A "current outflow terminal" of the power semiconductor device corresponds to the "source terminal" of the MOSFET, the "emitter terminal" of the IGBT and the transistor, and the "cathode terminal" of the thyristor and the GTO. A "control terminal" of the power semiconductor device corresponds to the "gate terminal" of the MOSFET, the IGBT, the thyristor and the GTO, and the "base terminal" of the transistor.

Hereinafter, while an example with a power semiconductor device that is a MOSFET will be described, each embodiment of the present disclosure is also applicable to an IGBT, a thyristor, a GTO, or a transistor. When the power semiconductor device is implemented as an IGBT, the current inflow terminal, or a "drain," is read as a "collector" and the current outflow terminal, or a "source," is read as an "emitter," and each embodiment of the present disclosure is applied thereto. When the power semiconductor device is implemented as a transistor, the control terminal, or a "gate," is read as a "base," the current inflow terminal, or a "drain," is read as a "collector" and the current outflow terminal, or a "source," is read as an "emitter," and each embodiment of the present disclosure is applied thereto. When the power semiconductor device is implemented as a thyristor or a GTO, the current inflow terminal, or a "drain," is read as an "anode" and the current outflow terminal, or a "source," is read as a "cathode," and each embodiment of the present disclosure is applied thereto.

### <First Embodiment>

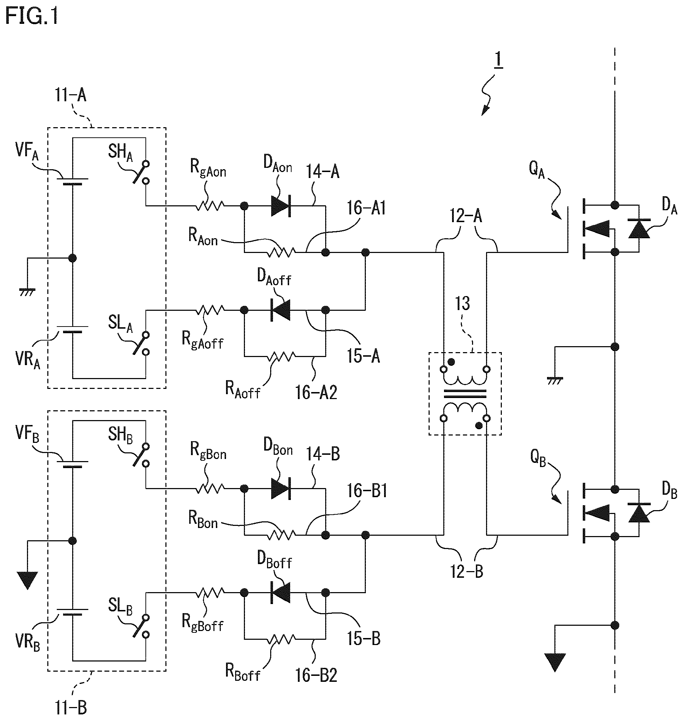

Fig. 1 is a circuit diagram of a gate drive device according to a first embodiment of the present disclosure.

While a gate drive device 1 according to the first embodiment and second to fourth embodiments of the present disclosure drives on/off a plurality of series-connected power semiconductor devices and herein as an example drives on/off two series-connected power semiconductor devices Q_{A} and Q_{B} for the sake of illustration, the following description is also applicable to driving on/off three or more series-connected power semiconductor devices.

A feedback diode D_{A} is connected to power semiconductor device Q_{A} in antiparallel. Similarly, a feedback diode D_{B} is connected to power semiconductor device Q_{B} in antiparallel.

Gate drive device 1 according to the first embodiment of the present disclosure comprises gate drive voltage output units 11-A and 11-B, gate lines 12-A and 12-B, a magnetic coupling unit 13, first wiring routes 14-A and 14-B, second wiring routes 15-A and 15-B, and third wiring routes 16-A1, 16-A2, 16-B1, and 16-B2.

Gate drive voltage output unit 11-A is associated with power semiconductor device Q_{A}, and outputs a positive gate drive voltage (e.g., 17 V) corresponding to an on signal of a gate signal, and 0 V or a negative gate drive voltage (e.g., -11 V) corresponding to an off signal of the gate signal. Gate drive voltage output unit 11-B is associated with power semiconductor device Q_{B}, and outputs the positive gate drive voltage (e.g., 17 V) corresponding to the on signal of the gate signal and 0 V or the negative gate drive voltage (e.g., -11 V) corresponding to the off signal of the gate signal. Gate drive voltage output units 11-A and 11-B insulate a received on or off signal or convert the signal in level in voltage, and output gate drive voltage corresponding to power semiconductor devices Q_{A} and Q_{B}. In order to simplify the description, while it is assumed hereinafter that the off signal of the gate signal corresponds to a gate drive voltage of 0 V unless otherwise specified, the off signal of the gate signal may be a negative gate drive voltage.

Gate drive voltage output unit 11-A includes a positive potential output unit VF_{A} that outputs a positive potential of the gate drive voltage, a negative potential output unit VR_{A} that outputs a negative potential of the gate drive voltage, a positive switch SH_{A}, and a negative switch SL_{A}. Negative potential output unit VR_{A} is connected to positive potential output unit VF_{A} in series. In gate drive voltage output unit 11-A, when positive switch SH_{A} turns on and negative switch SL_{A} turns off, gate drive voltage output unit 11-A outputs at a positive terminal the positive gate drive voltage (e.g., 17 V) corresponding to the on signal of the gate signal. In gate drive voltage output unit 11-A, when positive switch SH_{A} turns off and negative switch SL_{A} turns on, gate drive voltage output unit 11-A outputs at a negative terminal 0 V or the negative gate drive voltage (e.g., -11 V) corresponding to the off signal of the gate signal.

Similarly, gate drive voltage output unit 11-B includes a positive potential output unit VF_{B} that outputs the positive potential of the gate drive voltage, a negative potential output unit VR_{B} that outputs the negative potential of the gate drive voltage, a positive switch SH_{B}, and a negative switch SL_{B}. Negative potential output unit VR_{B} is connected to positive potential output unit VF_{B} in series. In gate drive voltage output unit 11-B, when positive switch SH_{B} turns on and negative switch SL_{B} turns off, gate drive voltage output unit 11-B outputs at a positive terminal the positive gate drive voltage (e.g., 17 V) corresponding to the on signal of the gate signal. In gate drive voltage output unit 11-B, when positive switch SH_{B} turns off and negative switch SL_{B} turns on, gate drive voltage output unit 11-B outputs at a negative terminal 0 V or the negative gate drive voltage (e.g., -11 V) corresponding to the off signal of the gate signal.

Positive switch SH_{A} in gate drive voltage output unit 11-A and positive switch SH_{B} in gate drive voltage output unit 11-B synchronously turn on and off, that is, the positive switches SH_{A} and SH_{B} turn on and off at the same timing. Similarly, SL_{A} in gate drive voltage output unit 11-A and negative switch SL_{B} in gate drive voltage output unit 11-B synchronously turn on and off, that is, negative switches SL_{A} and SL_{B} turn on and off at the same timing. Therefore, when gate drive voltage output unit 11-A outputs the positive gate drive voltage at its positive terminal, gate drive voltage output unit 11-B outputs the positive gate drive voltage at its positive terminal. When gate drive voltage output unit 11-A outputs the gate drive voltage of 0 V at its negative terminal, gate drive voltage output unit 11-B outputs the gate drive voltage of 0 V at its negative terminal.

Gate lines 12-A and 12-B are associated with gate drive voltage output units 11-A and 11-B, respectively, and are connected to the gate terminals of power semiconductor devices Q_{A} and Q_{B} associated with the gate drive voltage output units, respectively.

Gate line 12-A supplies the gate drive voltage output from gate drive voltage output unit 11-A to the gate terminal, or a control terminal, of power semiconductor device Q_{A} associated therewith. Power semiconductor device Q_{A} turns on when the positive gate drive voltage is applied to the gate terminal of power semiconductor device Q_{A}, and power semiconductor device Q_{A} turns off when the gate drive voltage of 0 V is applied to the gate terminal of power semiconductor device Q_{A}.

Gate line 12-B supplies the gate drive voltage output from gate drive voltage output unit 11-B to the gate terminal, or a control terminal, of power semiconductor device Q_{B} associated therewith. Power semiconductor device Q_{B} turns on when the positive gate drive voltage is applied to the gate terminal of power semiconductor device Q_{B}, and power semiconductor device Q_{B} turns off when the gate drive voltage of 0 V is applied to the gate terminal of power semiconductor device Q_{B}.

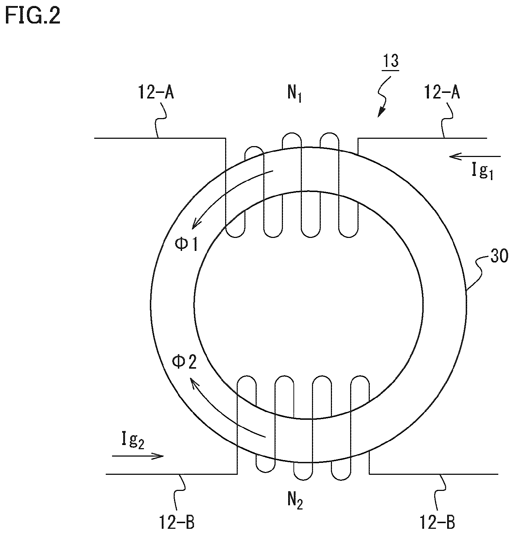

Magnetic coupling unit 13 magnetically couples gate lines 12-A and 12-B together. Fig. 2 is a diagram for exemplarily illustrating a magnetic coupling unit in the gate drive device according to the first to fourth embodiments of the present disclosure. Fig. 2 is also applicable to second to fourth embodiments described hereinafter. Magnetic coupling unit 13 includes a magnetic body 30. Gate lines 12-A and 12-B are wound on magnetic body 30. For example, as shown in Fig. 2, when a gate current Ig₁ flows, a magnetic flux Φ1 is produced through magnetic body 30 across gate line 12-B. Similarly, when a gate current Ig₂ flows, a magnetic flux Φ2 is produced through magnetic body 30 across gate line 12-A. This magnetically couples gate lines 12-A and 12-B together. A number of turns N₁ of gate line 12-A on magnetic body 30 and a number of turns N₂ of gate line 12-B on magnetic body 30 are equal to each other, and when gate currents Ig₁ and Ig₂ are equal to each other, |Φ1| = |Φ2|, whereas when gate currents Ig₁ and Ig₂ are opposite in polarity, Φ1 and Φ2 are opposite in polarity.

For example, when power semiconductor devices Q_{A} and Q_{B} do not turn off at the same timing and power semiconductor device Q_{A} turns off earlier than power semiconductor device Q_{B}, and gate current Ig₁ flows out earlier than gate current Ig₂, magnetic flux Φ1 and magnetic flux Φ2 will not be equal, and a magnetic flux of |Φ1 - Φ2| is produced in magnetic body 30 and magnetic coupling is provided. When this is done, an inductance L1 is produced in gate line 12-A and an inductance L2 is produced in gate line 12-B, and these inductances L1 and L2 are proportional to |Φ1 - Φ2|. As an unbalance between gate currents Ig₁ and Ig₂ increases, inductances L1 and L2 also increase. Furthermore, as inductances L1 and L2 increase, the impedances of gate lines 12-A and 12-B increase, and gate currents Ig₁ and Ig₂ do not easily flow. As a result, depending on the unbalance between gate currents Ig₁ and Ig₂, gate lines 12-A and 12-B vary in impedance and operation can be performed so that gate currents Ig₁ and Ig₂ match.

Magnetic coupling unit 13 thus has a function of causing an operation so that gate currents Ig₁ and Ig₂ match even when power semiconductor devices Q_{A} and Q_{B} do not turn off at the same timing.

A positive gate resistor R_{gAon} is connected to the positive terminal of gate drive voltage output unit 11-A, and a negative gate resistor R_{gAoff} is connected to the negative terminal thereof. Similarly, a positive gate resistor R_{gBon} is connected to the positive terminal of gate drive voltage output unit 11-B, and a negative gate resistor R_{gBoff} is connected to the negative terminal thereof.

First wiring route 14-A associated with power semiconductor device Q_{A} is a path for a current flowing from gate drive voltage output unit 11-A toward gate line 12-A associated with gate drive voltage output unit 11-A, and is provided between positive gate resistor R_{gAon} and gate line 12-A. First wiring route 14-A includes a first diode D_{Aon} having an anode connected via positive gate resistor R_{gAon} to a wire located on a side leading to the positive terminal of gate drive voltage output unit 11-A and a cathode connected to a wire located on a side leading to magnetic coupling unit 13, or gate line 12-A.

First wiring route 14-B associated with power semiconductor device Q_{B} is a path for a current flowing from gate drive voltage output unit 11-B toward gate line 12-B associated with gate drive voltage output unit 11-B, and is provided between positive gate resistor R_{gBon} and gate line 12-B. First wiring route 14-B includes a first diode D_{Bon} having an anode connected via positive gate resistor R_{gBon} to a wire located on a side leading to the positive terminal of gate drive voltage output unit 11-B and a cathode connected to a wire located on a side leading to magnetic coupling unit 13, or gate line 12-B.

Second wiring route 15-A associated with power semiconductor device Q_{A} is a path for a current flowing from gate line 12-A connected to first wiring route 14-A toward gate drive voltage output unit 11-A associated with gate line 12-A, and is provided between negative gate resistor R_{gAoff} and gate line 12-A. Second wiring route 15-A includes a second diode D_{Aoff} having a cathode connected via negative gate resistor R_{gAoff} to a wire located on a side leading to the negative terminal of gate drive voltage output unit 11-A and an anode connected to a wire located on a side leading to magnetic coupling unit 13, or gate line 12-A.

Second wiring route 15-B associated with power semiconductor device Q_{B} is a path for a current flowing from gate line 12-B connected to first wiring route 14-B toward gate drive voltage output unit 11-B associated with gate line 12-B, and is provided between negative gate resistor R_{gBoff} and gate line 12-B. Second wiring route 15-B includes a second diode D_{Boff} having a cathode connected via negative gate resistor R_{gBoff} to a wire located on a side leading to the negative terminal of gate drive voltage output unit 11-B and an anode connected to a wire located on a side leading to magnetic coupling unit 13, or gate line 12-B.

Third wiring routes 16-A1 and 16-A2 associated with power semiconductor device Q_{A} attenuate an exciting current generated in magnetic coupling unit 13. Third wiring route 16-A1 includes a first resistor R_{Aon} connected to first diode D_{Aon} in parallel. Third wiring route 16-A2 includes a second resistor R_{Aoff} connected to second diode D_{Aoff} in parallel.

Third wiring routes 16-B1 and 16-B2 associated with power semiconductor device Q_{B} attenuate an exciting current generated in magnetic coupling unit 13. Third wiring route 16-B1 includes a first resistor R_{Bon} connected to first diode D_{Bon} in parallel. Third wiring route 16-B2 includes a second resistor R_{Boff} connected to second diode D_{Boff} in parallel.

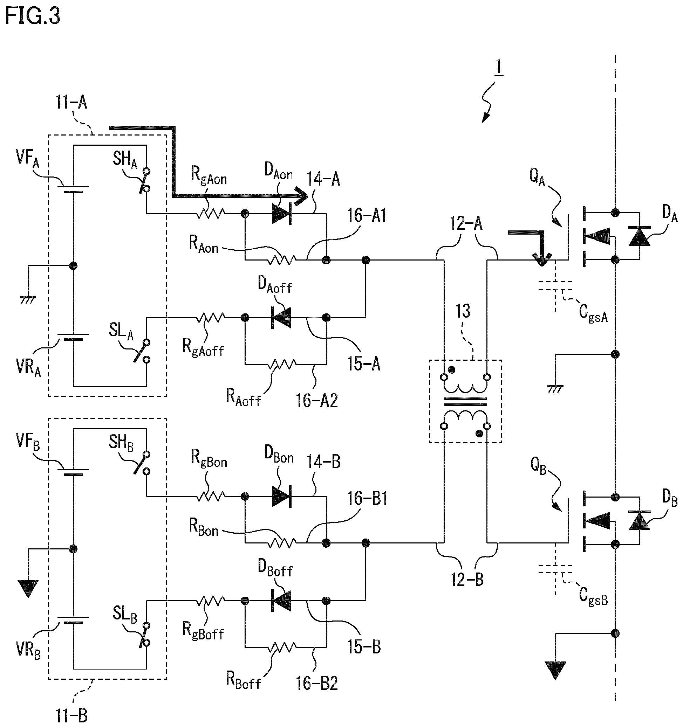

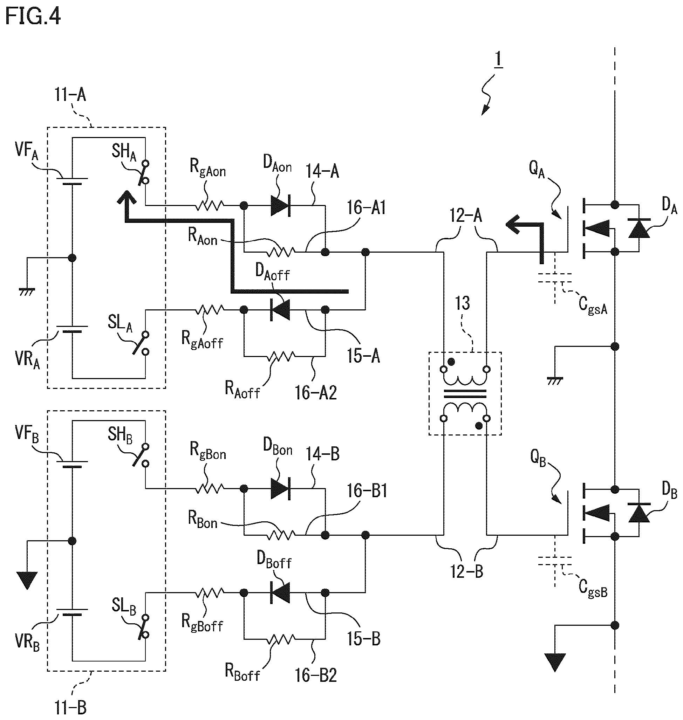

Subsequently, an operation of gate drive device 1 according to the first embodiment of the present disclosure will be described with reference to Figs. 3 and 4.

Figs. 3 and 4 are circuit diagrams for illustrating how a current flows in the gate drive device when power semiconductor device Q_{A} turns on according to the first embodiment of the present disclosure. In Figs. 3 and 4, Cgs_{A} represents an input capacitance when power semiconductor device Q_{A} is seen on the side of the gate terminal, and Cgs_{B} represents an input capacitance when power semiconductor device Q_{B} is seen on the side of the gate terminal.

Turning on power semiconductor device Q_{A} is implemented when positive switch SH_{A} and negative switch SL_{A} of gate drive voltage output unit 11-A turn on and off, respectively, and accordingly, a positive gate drive voltage (e.g., 17 V) is output from the positive terminal of gate drive voltage output unit 11-A and applied to the gate terminal of power semiconductor device Q_{A}. When the positive potential of the gate drive voltage output from positive potential output unit VF_{A} of gate drive voltage output unit 11-A is applied to power semiconductor device Q_{A} earlier than power semiconductor device Q_{B}, the gate-source voltage of power semiconductor device Q_{A} starts to increase from negative toward positive in potential. When this is done, as indicated in Fig. 3 by thick arrows, a current flows from positive potential output unit VF_{A} via positive switch SH_{A}, positive gate resistor R_{gAon}, first diode D_{Aon} on first wiring route 14-A, and magnetic coupling unit 13 to input capacitance Cgs_{A} of power semiconductor device Q_{A}. In order to cause power semiconductor device Q_{A} to switch at as high a speed as possible, positive gate resistor R_{gAon} is set to a small value, and accordingly, a resonant condition may be satisfied and the current oscillates. As the current oscillates, the current flows backward from power semiconductor device Q_{A} toward positive potential output unit VF_{A} when input capacitance Cgs_{A} of power semiconductor device Q_{A} is equal to or larger in voltage than the positive potential of the gate drive voltage output from positive potential output unit VF_{A}. The current follows a route, as indicated in Fig. 4 by thick arrows, from input capacitance Cgs_{A} of power semiconductor device Q_{A} via magnetic coupling unit 13, first resistor R_{Aon} on third wiring route 16-A1, positive gate resistor R_{gAon} and positive switch SH_{A} to positive potential output unit VF_{A}. First resistor R_{Aon}, having a value that is large to an extent that can attenuate the current, attenuates the current and thus suppresses oscillation of the gate-source voltage of power semiconductor device Q_{A}.

When power semiconductor device Q_{A} turns off, a current flows in a direction opposite to the current flowing when power semiconductor device Q_{A} turns on. Turning off power semiconductor device Q_{A} is implemented when positive switch SH_{A} and negative switch SL_{A} of gate drive voltage output unit 11-A turn off and on, respectively, and accordingly, a negative gate drive voltage (e.g., 0 V or less) is output from the negative terminal of gate drive voltage output unit 11-A and applied to the gate terminal of power semiconductor device Q_{A}. When the negative potential of the gate drive voltage output from negative potential output unit VR_{A} of gate drive voltage output unit 11-A is applied to power semiconductor device Q_{A} earlier than power semiconductor device Q_{B}, the gate-source voltage of power semiconductor device Q_{A} starts to decrease from positive toward negative in potential. When this is done, a current flows from input capacitance Cgs_{A} via magnetic coupling unit 13, second diode D_{Aoff} on second wiring route 15-A, negative gate resistor R_{gAoff}, and negative switch SL_{A} to negative potential output unit VR_{A}. In order to cause power semiconductor device Q_{B} to switch at as high a speed as possible, negative gate resistor R_{gAoff} is set to a small value, and accordingly, a resonant condition may be satisfied and the current oscillates. As the current oscillates, the current flows backward from negative potential output unit VR_{A} toward power semiconductor device Q_{A} when input capacitance Cgs_{A} of power semiconductor device Q_{A} is equal to or smaller in voltage than the negative potential of the gate drive voltage output from negative potential output unit VR_{A}. The current follows a route from negative potential output unit VR_{A} via negative switch SL_{A}, negative gate resistor R_{gAoff}, second resistor R_{Aoff} on third wiring route 16-A2, and magnetic coupling unit 13 to input capacitance Cgs_{A} of power semiconductor device Q_{A}. Second resistor R_{Aoff}, having a value that is large to an extent that can attenuate the current, attenuates the current and thus suppresses oscillation of the gate-source voltage of power semiconductor device Q_{A}.

While how a current flows in the gate drive device when power semiconductor device Q_{A} turns on/off has been described above, how a current flows in the gate drive device when power semiconductor device Q_{B} turns on/off is similarly described.

When gate drive device 1 described above is used for a power conversion apparatus in which a plurality of arms each provided with a plurality of series-connected power semiconductor devices are connected in series, the gate drive device can drive on/off the power semiconductor devices.

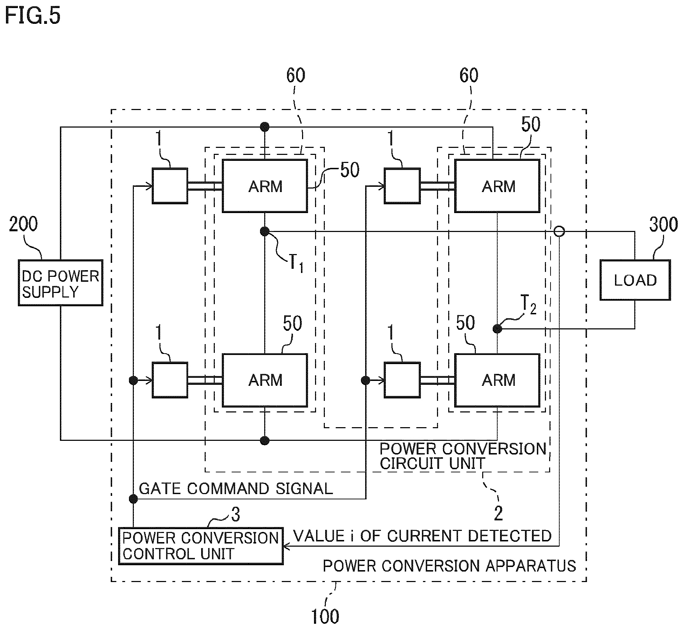

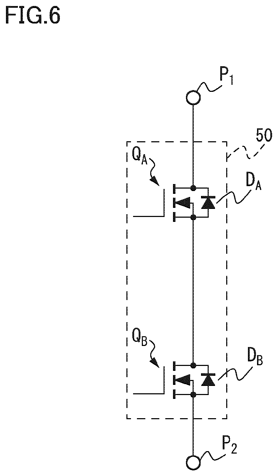

Fig. 5 is a diagram for illustrating a power conversion apparatus comprising a gate drive device according to one embodiment of the present disclosure. Fig. 6 is a circuit diagram of an arm provided in the power conversion apparatus shown in Fig. 5. Herein, as one example, an example in which an arm 50 is composed of two power semiconductor devices Q_{A} and Q_{B} connected in series will be described.

A power conversion apparatus 100 according to an embodiment of the present disclosure comprises gate drive device 1 described above, a power conversion circuit unit 2 that has arm 50 provided with a plurality of series-connected power semiconductor devices and performs a power conversion operation in response to the power semiconductor devices turning on/off, and a power conversion control unit 3 that controls the power conversion operation of power conversion circuit unit 2.

As shown in Fig. 6, arm 50 is composed for example of two power semiconductor devices Q_{A} and Q_{B} connected in series. A terminal P₁ is led out from the drain terminal of power semiconductor device Q_{A}, and a terminal P₂ is led out from the source terminal of power semiconductor device Q_{B}. In power conversion circuit unit 2, terminal P₂ of an arm 50 is connected to terminal P₁ of another arm 50, and their connection point is connected to one terminal of a load. In the example illustrated in Fig. 5, two arms 50 are connected in series to form one leg 60, and two legs 60 configure power conversion circuit unit 2.

A DC power supply 200 is connected to leg 60 composed of arms 50 connected in series. A load 300 is connected between a terminal T₁ between arms 50 series connected in one leg 60 and a terminal T₂ between arms 50 series connected in the other leg 60.

Gate drive device 1 is provided for arm 50. Power semiconductor devices Q_{A} and Q_{B} in each arm 50 are driven on/off by gate drive device 1 associated therewith. That is, gate drive voltage output units 11-A and 11-B generate gate drive voltages, respectively, as described above and then turn on/off positive switches SH_{A} and SH_{B} and negative switches SL_{A} and SL_{B} to control voltages applied to the gate terminals of power semiconductor devices Q_{A} and Q_{B}.

Power conversion control unit 3 controls turning on/off positive switches SH_{A} and SH_{B} and negative switches SL_{A} and SL_{B} in each gate drive device 1. That is, power conversion control unit 3 controls turning on/off positive switches SH_{A} and SH_{B} and negative switches SL_{A} and SL_{B} in each gate drive device 1 to control voltages applied to the gate terminals of power semiconductor devices Q_{A} and Q_{B}, and accordingly, power semiconductor devices Q_{A} and Q_{B} turn on/off. Thus, power conversion circuit unit 2 will receive DC power from DC power supply 200, convert the received DC power to desired power, and supply the desired power to load 300, that is, perform the power conversion operation. Power conversion control unit 3 generates a gate signal to control turning on/off positive switches SH_{A} and SH_{B} and negative switches SL_{A} and SL_{B} in each gate drive device 1 to eliminate deviation between a value i of a detected current flowing from positive terminal T₁ to load 300 and a command that is a control target value for the current, for example.

A computing device (a processor) is provided in power conversion apparatus 100. The computing device includes power conversion control unit 3. Power conversion control unit 3 included in the computing device is, for example, a functional module implemented by a computer program executed on the processor. For example, when power conversion control unit 3 is constructed in the form of a computer program, the function can be implemented by operating the computing device in accordance with the computer program. The computer program for executing the process of power conversion control unit 3 may be provided in a form recorded in a computer-readable recording medium such as a semiconductor memory, a magnetic recording medium, or an optical recording medium. Alternatively, power conversion control unit 3 may be implemented as a semiconductor integrated circuit in which a computer program is written to implement the function.

Subsequently will be described an unbalance in voltage sharing (an unbalance in drain-source voltage) for each of power semiconductor devices Q_{A} and Q_{B} in the invention based on PTL 1 (Japanese Patent No. 4396036).

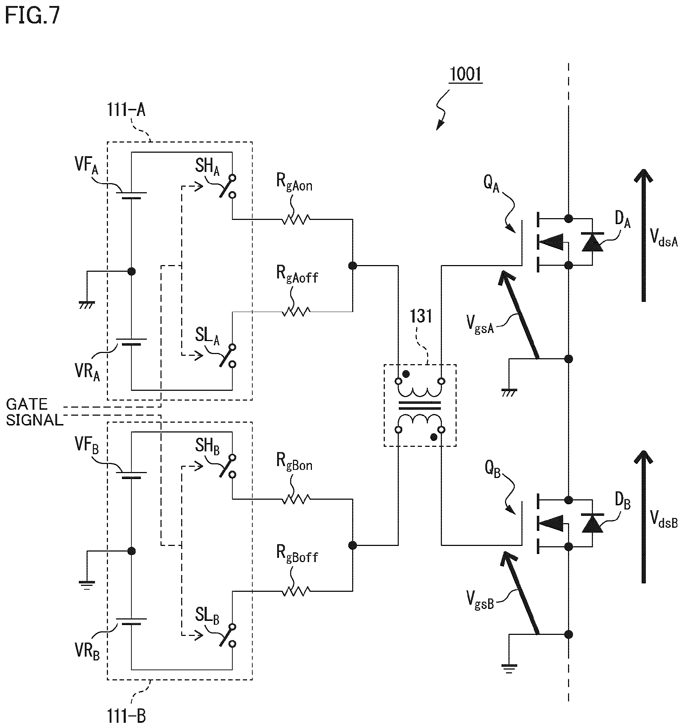

Fig. 7 is a circuit diagram of a gate drive device based on the invention described in PTL 1 (Japanese Patent No. 4396036).

A gate drive device 1001 based on the invention described in PTL 1 (Japanese Patent No. 4396036) is provided for power semiconductor devices Q_{A} and Q_{B}, and comprises gate drive voltage output units 111-A and 111-B that output gate drive voltages, and a magnetic coupling unit 131 that magnetically couples together gate lines that receive the gate drive voltages output from gate drive voltage output units 111-A and 111-B and supply the received gate drive voltages to the gate terminals respectively of power semiconductor devices Q_{A} and Q_{B} associated with gate drive voltage output units 111-A and 111-B, respectively. Feedback diode D_{A} is connected to power semiconductor device Q_{A} in antiparallel. Similarly, feedback diode D_{B} is connected to power semiconductor device Q_{B} in antiparallel. Gate drive voltage output unit 111-A includes positive potential output unit VF_{A} that outputs a positive potential of the gate drive voltage, negative potential output unit VR_{A} that outputs a negative potential of the gate drive voltage, positive switch SH_{A}, and negative switch SL_{A}. Negative potential output unit VR_{A}, is connected to positive potential output unit VF_{A} in series. Gate drive voltage output unit 111-B includes positive potential output unit VF_{B} that outputs a positive potential of the gate drive voltage, negative potential output unit VR_{B} that outputs a negative potential of the gate drive voltage, positive switch SH_{B}, and negative switch SL_{B}. Positive gate resistor R_{gAon} is connected to a positive terminal of gate drive voltage output unit 111-A, and negative gate resistor R_{gAoff} is connected to a negative terminal thereof. Positive gate resistor R_{gBon} is connected to a positive terminal of gate drive voltage output unit 111-B, and negative gate resistor R_{gBoff} is connected to a negative terminal thereof.

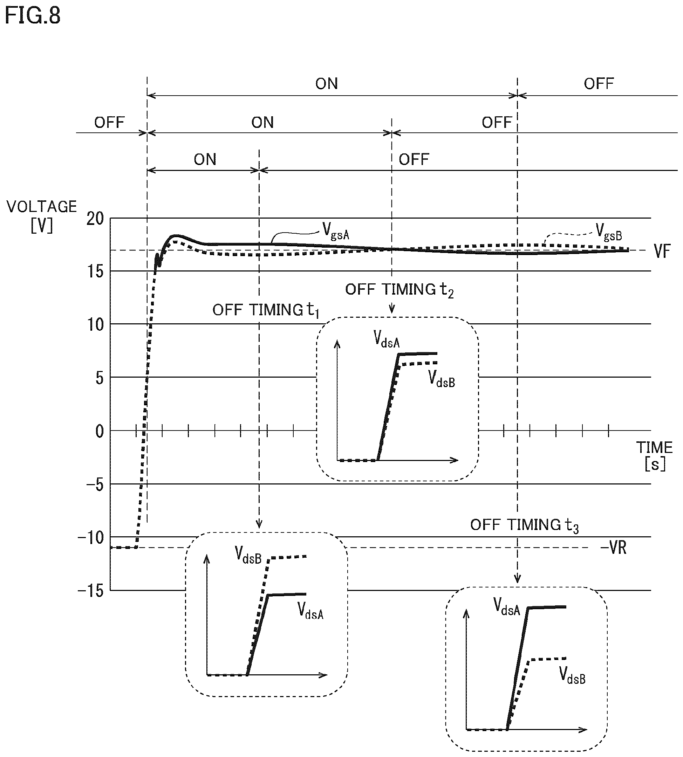

Fig. 8 is a diagram for exemplarily illustrating a waveform of a gate-source voltage of each power semiconductor device when a transition is made from an off state to an on state while a gate signal is shifted and thus transmitted in the invention based on PTL 1 (Japanese Patent No. 4396036). In Fig. 8, as an example, an on/off signal of a gate signal for power semiconductor device Q_{A} is output 250 ns earlier than an on/off signal of a gate signal for power semiconductor device Q_{B}.

As shown in Fig. 8, gate-source voltages V_{gsA} and V_{gsB} oscillate while power semiconductor devices Q_{A} and Q_{B} are turned on. When the devices shift to the off state while the oscillation continues, then, depending on the duration for which the devices are held on, an unbalanced state is caused in voltage applied to the devices generated when the devices turn off.

For example, at an off timing t₂, gate-source voltage V_{gsA} of power semiconductor device Q_{A} and gate-source voltage V_{gsb} of power semiconductor device Q_{B} are equal. As the off signal of the gate signal for power semiconductor device Q_{A} is output 250 ns earlier than the off signal of the gate signal for power semiconductor device Q_{B}, the shifted transmission of the gate signal causes an unbalance in voltage, and accordingly, a voltage applied to power semiconductor device Q_{A} (or a drain-source voltage) V_{dsA} is slightly higher than a voltage applied to power semiconductor device Q_{B} (or a drain-source voltage) V_{dsB}.

For example, at an off timing t₁, gate-source voltage V_{gsA} of power semiconductor device Q_{A} is higher than gate-source voltage V_{gsb} of power semiconductor device Q_{B}. As turning off power semiconductor device Q_{A} is started while gate-source voltage V_{gsA} of power semiconductor device Q_{A} is higher than gate-source voltage V_{gsb} of power semiconductor device Q_{B}, power semiconductor device Q_{A} starts turning off later than power semiconductor device Q_{B} starts turning off. Accordingly, a voltage applied to power semiconductor device Q_{B} (or drain-source voltage) V_{dsB} is higher than a voltage applied to power semiconductor device Q_{A} (or drain-source voltage) V_{dsA}.

For example, at an off timing t₃, gate-source voltage V_{gsb} of power semiconductor device Q_{B} is higher than gate-source voltage V_{gsA} of power semiconductor device Q_{A}. As turning off power semiconductor device Q_{B} is started while gate-source voltage V_{gsb} of power semiconductor device Q_{B} is higher than gate-source voltage V_{gsA} of power semiconductor device Q_{A}, power semiconductor device Q_{B} starts turning off later than power semiconductor device Q_{A} starts turning off. Accordingly, a voltage applied to power semiconductor device Q_{A} (or drain-source voltage) V_{dsA} is higher than a voltage applied to power semiconductor device Q_{B} (or drain-source voltage) V_{dsB}. Further, as the off signal of the gate signal for power semiconductor device Q_{A} is output 250 ns earlier than the off signal of the gate signal for power semiconductor device Q_{B}, an even larger difference is provided between the voltage applied to power semiconductor device Q_{A} (or drain-source voltage) V_{dsA} and the voltage applied to power semiconductor device Q_{B} (or drain-source voltage) V_{dsB}.

While a waveform in gate-source voltage of each power semiconductor device when it transitions from the off state to the on state has been described above, a similar description is also provided for transition from the on state to the off state.

When the gate signals for power semiconductor devices Q_{A} and Q_{B} are shifted and thus transmitted, or when there is a difference in gate-source voltage, an unbalance is caused in voltage sharing for each of power semiconductor devices Q_{A} and Q_{B} (or an unbalance in drain-source voltage) in a switching operation.

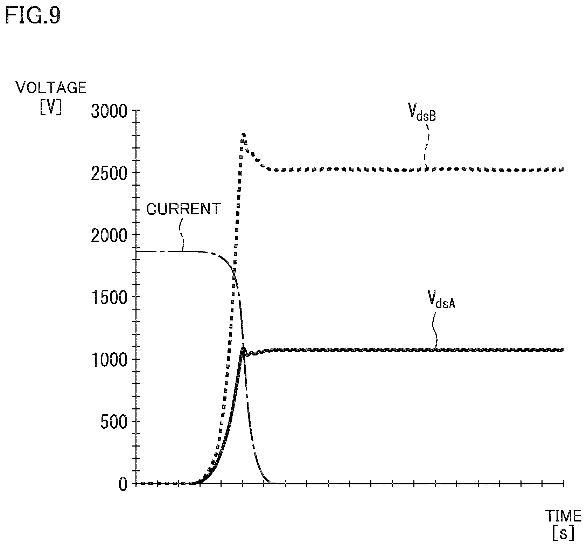

Fig. 9 is a diagram for exemplarily illustrating drain-source voltages of power semiconductor devices Q_{A} and Q_{B} and a drain current flowing from the drain to the source when power semiconductor devices Q_{A} and Q_{B} transition from an on state to an off state while voltage sharing is unbalanced in the invention based on PTL 1 (Japanese Patent No. 4396036). When power semiconductor devices Q_{A} and Q_{B} transition from the on state to the off state, the drain current starts to decrease from a value and simultaneously, drain-source voltages V_{dsA} and V_{dsB} of power semiconductor devices Q_{A} and Q_{B} increase. When there is some difference between a switching operation of power semiconductor device Q_{A} and that of power semiconductor device Q_{B}, voltage sharing after power semiconductor devices Q_{A} and Q_{B} turn off is unbalanced.

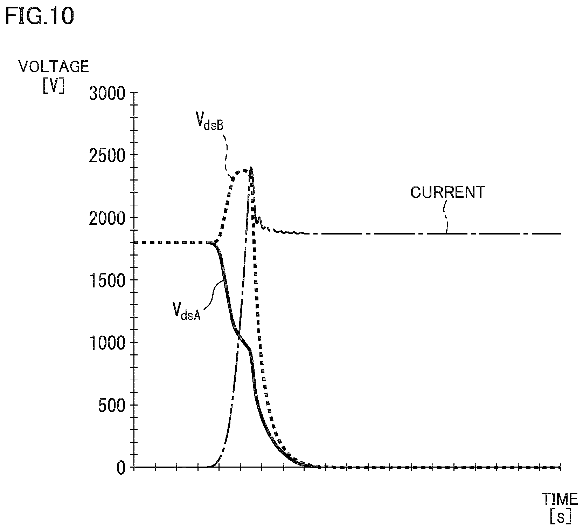

Fig. 10 is a diagram for exemplarily illustrating drain-source voltages of power semiconductor devices Q_{A} and Q_{B} and a drain current flowing from the drain to the source when power semiconductor devices Q_{A} and Q_{B} transition from the off state to the on state while voltage sharing is unbalanced in the invention based on PTL 1 (Japanese Patent No. 4396036). When power semiconductor devices Q_{A} and Q_{B} transition from the off state to the on state, the drain current starts to increase from zero, and simultaneously, drain-source voltage V_{dsA} of power semiconductor device Q_{A}, which turns on earlier, decreases and drain-source voltage V_{dsB} of power semiconductor device Q_{B}, which turns on later, increases. As power semiconductor devices Q_{A} and Q_{B} are continuously held on, drain-source voltages V_{dsA} and V_{dsB} of power semiconductor devices Q_{A} and Q_{B} come close to zero, although an unbalance is caused in voltage sharing for power semiconductor devices Q_{A} and Q_{B} around before and after switching from the off state to the on state.

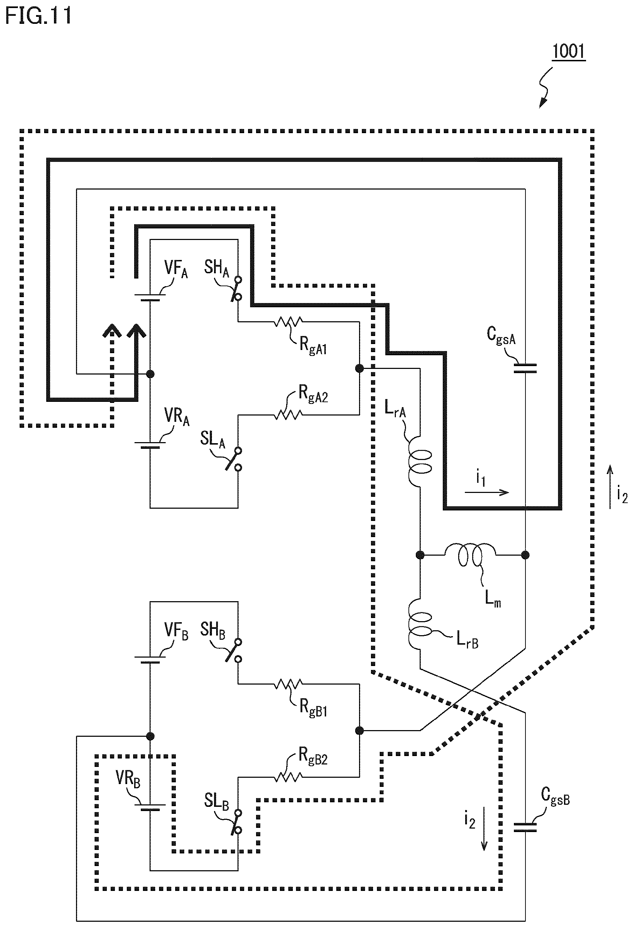

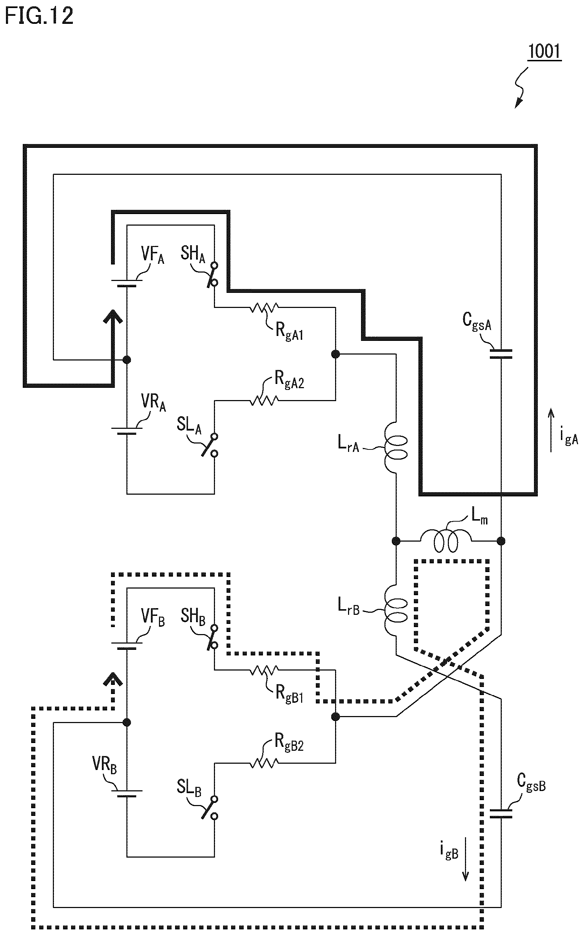

Subsequently, why each power semiconductor device has oscillating gate-source voltage will be described with reference to Figs. 11 and 12.

Fig. 11 is an equivalent circuit diagram showing how a current flows in the invention based on PTL 1 (Japanese Patent No. 4396036) when a power semiconductor device transitions from an off state to an on state while a gate signal is shifted and thus transmitted. Fig. 12 is an equivalent circuit diagram showing how a current flows in the invention based on PTL 1 (Japanese Patent No. 4396036) when the power semiconductor device transitions from the off state to the on state while the gate signal is transmitted without being shifted. In Figs. 11 and 12, Cgs_{A} represents an input capacitance when power semiconductor device Q_{A} is seen on the side of the gate terminal, and Cgs_{B} represents an input capacitance when power semiconductor device Q_{B} is seen on the side of the gate terminal. Lₘ represents an exciting inductance of magnetic coupling unit 131, and L_{rA} represents a leakage inductance for power semiconductor device Q_{A} and L_{rB} represents a leakage inductance for power semiconductor device Q_{B}. i_{gA} represents a current flowing through the gate terminal of power semiconductor device Q_{A}, and i_{gB} represents a current flowing through the gate terminal of power semiconductor device Q_{B}.

As an example, oscillation caused when the on signal of the gate signal for power semiconductor device Q_{A} is output earlier than the on signal of the gate signal for power semiconductor device Q_{B} will be described. As shown in Fig. 11, positive switch SH_{A} associated with power semiconductor device Q_{A} is turned on and the positive potential of the gate drive voltage output from positive potential output unit VF_{A} is output to power semiconductor device Q_{A}, and negative switch SL_{B} associated with power semiconductor device Q_{B} is held on and the negative potential of the gate drive voltage output from negative potential output unit VR_{B} is output to power semiconductor device Q_{B}.

In the state shown in Fig. 11, a difference in potential is caused across exciting inductance Lₘ, and an exciting current i₁ flows. An exciting current will flow through exciting inductance Lₘ. Current i_{gA} flowing through the gate terminal of power semiconductor device Q_{A} will be equal to i₁ + i₂, and current i_{gB} flowing through the gate terminal of power semiconductor device Q_{B} will be equal to i₂.

Exciting inductance Lₘ is designed to be large to some extent in order to match each gate current to suppress variation in timing of switching. Gate resistors R_{gA1}, R_{gA2}, R_{gS1}, and R_{gB2} have a value selected to be small to some extent in order to cause power semiconductor devices Q_{A} and Q_{B} to switch fast to suppress power loss. Therefore, it is difficult to avoid a resonant condition of an LCR series circuit, and currents flowing through the gate terminals of power semiconductor devices Q_{A} and Q_{B} oscillate and gate-source voltages V_{gsA} and V_{gsB} would oscillate.

Furthermore, in the state shown in Fig. 12, when the positive potential output from positive potential output unit VF_{A} in gate drive voltage output unit 111-A and the positive potential output from positive potential output unit VF_{B} in gate drive voltage output unit 111-B are equal, input capacitance Cgs_{A} of power semiconductor device Q_{A} and input capacitance Cgs_{B} of power semiconductor device Q_{B} store equal amounts of electric charge, leakage inductance L_{rA} for power semiconductor device Q_{A} and leakage inductance L_{rB} for power semiconductor device Q_{B} are equal in electromotive voltage, and gate resistor R_{gA1} and gate resistor R_{gB1} are equal in electromotive voltage, then, there is no difference in potential across exciting inductance Lₘ and an exciting current "i_{gA} - i_{gB}" will be zero, that is, no exciting current flows through exciting inductance Lₘ. As there is no exciting current flowing through exciting inductance Lₘ, gate-source voltages V_{gsA} and V_{gsB} of power semiconductor devices Q_{A} and Q_{B} do not oscillate.

However, if at least one of the following four parameters: the positive potentials output from positive potential output units VF_{A} and VF_{B}, the amounts of electric charge stored in input capacitances Cgs_{A} and Cgs_{B}, the electromotive voltages of leakage inductances L_{rA} and L_{rB}, and the electromotive voltages of gate resistors R_{gA1} and R_{gB1}, has a difference, i_{gA} - i_{gB} will not be zero and an exciting current will flow through exciting inductance Lₘ. Currents flowing through the gate terminals of power semiconductor devices Q_{A} and Q_{B} oscillate, and gate-source voltages V_{gsA} and V_{gsB} would oscillate.

Thus, an exciting current flows when at least one of the four parameters: the positive potentials output from positive potential output units VF_{A} and VF_{B}, the amounts of electric charge stored in input capacitances Cgs_{A} and Cgs_{B}, the electromotive voltages of leakage inductances L_{rA} and L_{rB}, and the electromotive voltages of gate resistors R_{gA1} and R_{gB1}, has a difference or when a gate signal is transmitted with a difference. The exciting current causes oscillation of a current flowing through the gate terminal of each power semiconductor device, and gate-source voltages V_{gsA} and V_{gsB} of power semiconductor devices Q_{A} and Q_{B} oscillate. The exciting current flows through exciting inductance Lₘ, gate resistors R_{gA1}, R_{gA2}, R_{gB1} and R_{gB2}, and input capacitances Cgs_{A} and Cgs_{B}. Exciting inductance Lₘ is designed to be large to some extent in order to match each gate current to suppress variation in timing of switching. Gate resistors R_{gA1}, R_{gA2}, R_{gB1}, and R_{gB2} have a value selected to be small to some extent in order to cause power semiconductor devices Q_{A} and Q_{B} to switch fast to suppress power loss. Therefore, it is difficult to avoid a resonant condition of an LCR series circuit, and currents flowing through the gate terminals of power semiconductor devices Q_{A} and Q_{B} oscillate and gate-source voltages V_{gsA} and V_{gsB} would oscillate.

In contrast, gate drive device 1 according to the first embodiment of the present disclosure can suppress oscillation of a current flowing through the gate terminal of each power semiconductor device, and hence an unbalance in voltage sharing for each power semiconductor device in a switching operation.

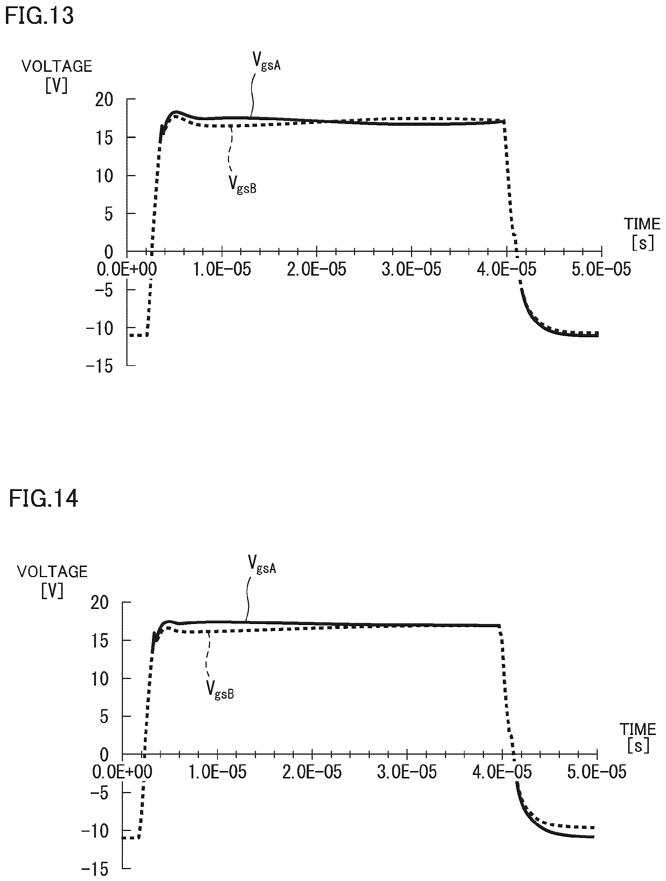

Hereinafter, a waveform of gate-source voltage when gate lines are magnetically coupled together in PTL 1 (Japanese Patent No. 4396036) and that of gate-source voltage in the first embodiment of the present disclosure will be compared and examined with reference to the simulations shown in Figs. 13 and 14.

Fig. 13 is a diagram representing a simulation of gate-source voltage in waveform in the invention based on PTL 1 (Japanese Patent No. 4396036). Fig. 14 is a diagram representing a simulation of gate-source voltage in waveform in the gate drive device according to the first embodiment of the present disclosure.

In the simulations, it is assumed that the off signal of the gate signal for power semiconductor device Q_{A} is output 250 ns earlier than the on signal of the gate signal for power semiconductor device Q_{B}. Power semiconductor devices Q_{A} and Q_{B} are SiC-MOSFETs having a withstand voltage of 3.3 kV/750 A, and the simulations are performed while it is assumed that a load current of 325 A flows when a voltage of 1.8 kV is applied. For a load, an inductive load is assumed. In the simulations, positive gate resistors R_{gAon} and R_{gBon} are set to 4.1 Ω, negative gate resistors R_{gAoff} and R_{gBoff} are set to 6.1 Ω, first resistors R_{Aon} and R_{Bon} are set to 36 Ω, second resistors R_{Aoff} and R_{Boff} are set to 34 Ω, positive potential output units VF_{A} and VF_{B} output gate drive voltage with a positive potential set to 17 V, and negative potential output units VR_{A} and VR_{B} output gate drive voltage with a negative potential set to -11 V.

As shown in Fig. 13, according to the invention based on PTL 1 (Japanese Patent No. 4396036), after gate-source voltages V_{gsA} and V_{gsB} of power semiconductor devices Q_{A} and Q_{B} increase from -11 V to 17 V, gate-source voltage V_{gsA} of power semiconductor device Q_{A} and gate-source voltage V_{gsB} of power semiconductor device Q_{B} oscillate out of phase by 180 degrees.

As shown in Fig. 14, according to the gate drive device of the first embodiment of the present disclosure, after gate-source voltages V_{gsA} and V_{gsB} of power semiconductor devices Q_{A} and Q_{B} increase from -11 V to 17 V, oscillation is attenuated, and after a period of time of 25 µs elapses, gate-source voltage V_{gsA} of power semiconductor device Q_{A} and gate-source voltage V_{gsB} of power semiconductor device Q_{B} have the same value. Thus, the gate drive device according to the first embodiment of the present disclosure can suppress oscillation of gate-source voltage and there is no difference in gate-source voltage at a time point when switching starts, and thus suppress an unbalance in voltage sharing for power semiconductor devices Q_{A} and Q_{B} in a switching operation. It should be noted, however, that a period of time of about 25 µs is required before gate-source voltage V_{gsA} of power semiconductor device Q_{A} and gate-source voltage V_{gsB} of power semiconductor device Q_{B} become equal, and in order to avoid switching while gate-source voltage V_{gsB} oscillates, it is necessary to ensure about 25 µs as a minimum on or off period of time.

### <Second Embodiment>

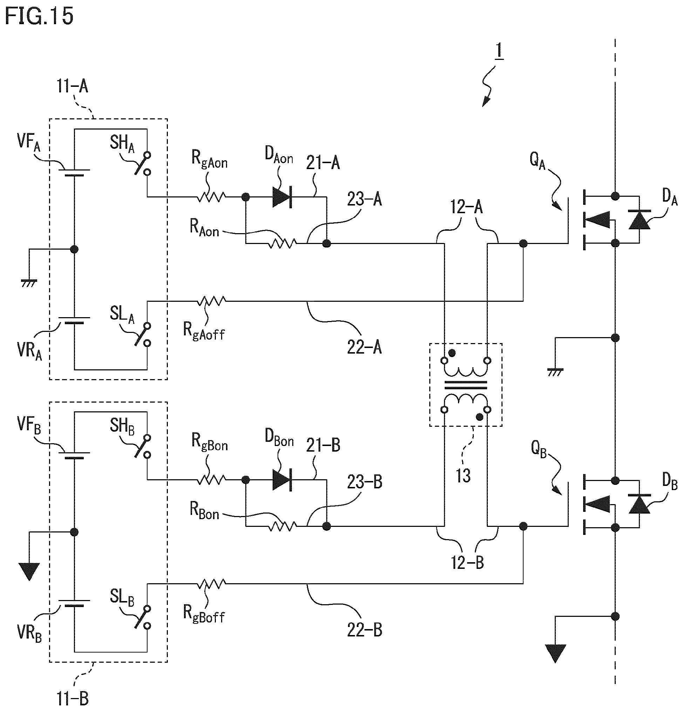

Fig. 15 is a circuit diagram of a gate drive device according to a second embodiment of the present disclosure.

The second embodiment of the present disclosure corresponds to the first embodiment without second diodes D_{Aoff} and D_{Boff} and second resistors R_{Aoff} and R_{Boff}.

Gate drive device 1 according to the second embodiment of the present disclosure comprises gate drive voltage output units 11-A and 11-B, gate lines 12-A and 12-B, magnetic coupling unit 13, fourth wiring routes 21-A and 21-B, fifth wiring routes 22-A and 22-B, and sixth wiring routes 23-A and 23-B.

Gate drive voltage output units 11-A and 11-B, gate lines 12-A and 12-B, and magnetic coupling unit 13 are as has been described in the first embodiment.

Positive gate resistor R_{gAon} is connected to the positive terminal of gate drive voltage output unit 11-A, and negative gate resistor R_{gAoff} is connected to the negative terminal thereof. Similarly, positive gate resistor R_{gBon} is connected to the positive terminal of gate drive voltage output unit 11-B, and negative gate resistor R_{gBoff} is connected to the negative terminal thereof.

Fourth wiring route 21-A associated with power semiconductor device Q_{A} is a path for a current flowing from gate drive voltage output unit 11-A toward gate line 12-A associated with gate drive voltage output unit 11-A, and is provided between positive gate resistor R_{gAon} and gate line 12-A. Fourth wiring route 21-A includes a fourth diode D_{Aon} having an anode connected via positive gate resistor R_{gAon} to a wire leading to the positive terminal of gate drive voltage output unit 11-A and a cathode connected to a wire leading to magnetic coupling unit 13, or gate line 12-A.

Fourth wiring route 21-B associated with power semiconductor device Q_{B} is a path for a current flowing from gate drive voltage output unit 11-B toward gate line 12-B associated with gate drive voltage output unit 11-B, and is provided between positive gate resistor R_{gBon} and gate line 12-B. Fourth wiring route 21-B includes a fourth diode D_{Bon} having an anode connected via positive gate resistor R_{gBon} to a wire leading to the positive terminal of gate drive voltage output unit 11-B and a cathode connected to a wire leading to magnetic coupling unit 13, or gate line 12-B.

Fifth wiring route 22-A associated with power semiconductor device Q_{A} is a path for a current flowing from the gate terminal of power semiconductor device Q_{A} to which gate line 12-A is connected toward gate drive voltage output unit 11-A associated with power semiconductor device Q_{A}, and is provided between negative gate resistor R_{gAoff} and power semiconductor device Q_{A}.

Fifth wiring route 22-B associated with power semiconductor device Q_{B} is a path for a current flowing from the gate terminal of power semiconductor device Q_{B} to which gate line 12-B is connected toward gate drive voltage output unit 11-B associated with power semiconductor device Q_{B}, and is provided between negative gate resistor R_{gBoff} and power semiconductor device Q_{B}.

Sixth wiring route 23-A associated with power semiconductor device Q_{A} attenuates an exciting current generated in magnetic coupling unit 13. Sixth wiring route 23-A includes a fourth resistor R_{Aon} connected to fourth diode D_{Aon} in parallel.

Sixth wiring route 23-B associated with power semiconductor device Q_{B} attenuates an exciting current generated in magnetic coupling unit 13. Sixth wiring route 23-B comprises a fourth resistor R_{Bon} connected to fourth diode D_{Bon} in parallel.

An operation by gate drive device 1 for turning on according to the second embodiment of the present disclosure is similar to the operation by gate drive device 1 for turning on according to the first embodiment described with reference to Figs. 3 and 4.

In contrast, an operation by gate drive device 1 for turning off according to the second embodiment of the present disclosure is different from the operation by gate drive device 1 for turning off according to the first embodiment in that the former applies gate-source voltage to power semiconductor devices Q_{A} and Q_{B} without passing through magnetic coupling unit 13. Turning off power semiconductor device Q_{A} is implemented when positive switch SH_{A} and negative switch SL_{A} of gate drive voltage output unit 11-A turn off and on, respectively, and accordingly, a negative gate drive voltage (e.g., 0 V or less) is output from the negative terminal of gate drive voltage output unit 11-A and applied to the gate terminal of power semiconductor device Q_{A}. When the negative potential of the gate drive voltage output from negative potential output unit VR_{A} of gate drive voltage output unit 11-A is applied to power semiconductor device Q_{A} earlier than power semiconductor device Q_{B}, the gate-source voltage of power semiconductor device Q_{A} starts to decrease from positive toward negative in potential. When this is done, a current flows from input capacitance Cgs_{A} of power semiconductor device Q_{A} via negative gate resistor R_{gAoff} and negative switch SL_{A} to negative potential output unit VR_{A}. Negative gate resistor R_{gAoff} is set to a small value in order to cause negative switch SL_{A} in gate drive voltage output unit 11-A to switch at as high a speed as possible. As the current does not flow through magnetic coupling unit 13, the current does not oscillate.

In the second embodiment of the present disclosure, the gate-source voltage does not oscillate while turning off is performed. Further, when turning on is performed with a gate signal transmitted for varying periods of time or power semiconductor devices Q_{A} and Q_{B} having varying characteristics, as in the invention based on PTL 1 (Japanese Patent No. 4396036), uniform voltage sharing for power semiconductor devices Q_{A} and Q_{B} is not provided, and an excessive voltage will be applied to one of the devices. However, as can be seen from the drain-source voltage and the drain current in waveform when an unbalance in voltage is caused as shown in Fig. 10, the unbalance in voltage applied when a transition is made from an off state to an on state is a phenomenon for a short period of time. Accordingly, the second embodiment of the present disclosure allows the unbalance in voltage applied when the transition is made from the off state to the on state, and suppresses oscillation of gate-source voltage caused by an exciting current of magnetic coupling unit 13 that is generated when a transition is made from the on state to the off state to suppress an unbalance in voltage caused in the off state. Thus, the second embodiment of the present disclosure eliminates the necessity of ensuring a minimum off period of time to avoid switching while gate-source voltages V_{gsA} and V_{gsB} oscillate.

### <Third Embodiment>

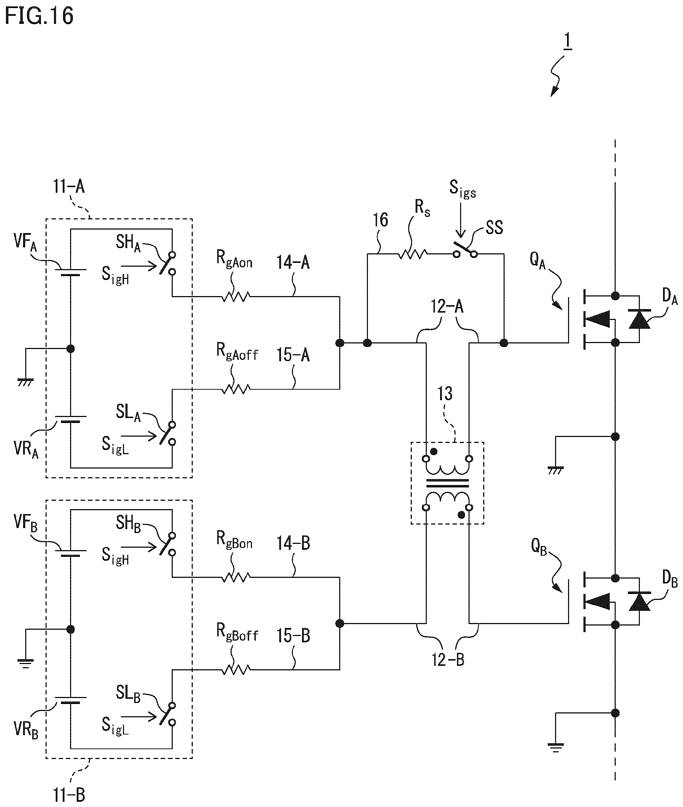

Fig. 16 is a circuit diagram of a gate drive device according to a third embodiment of the present disclosure.

Gate drive device 1 according to the third embodiment of the present disclosure comprises gate drive voltage output units 11-A and 11-B, gate lines 12-A and 12-B, magnetic coupling unit 13, first wiring routes 14-A and 14-B, second wiring routes 15-A and 15-B, and a third wiring route 16.

Gate drive voltage output units 11-A and 11-B, gate lines 12-A and 12-B, and magnetic coupling unit 13 are as has been described in the first embodiment.

Positive gate resistor R_{gAon} is connected to the positive terminal of gate drive voltage output unit 11-A, and negative gate resistor R_{gAoff} is connected to the negative terminal thereof. Similarly, positive gate resistor R_{gBon} is connected to the positive terminal of gate drive voltage output unit 11-B, and negative gate resistor R_{gBoff} is connected to the negative terminal thereof.

First wiring route 14-A associated with power semiconductor device Q_{A} is a path for a current flowing from gate drive voltage output unit 11-A toward gate line 12-A associated with gate drive voltage output unit 11-A, and is provided between positive gate resistor R_{gAon} and gate line 12-A.

First wiring route 14-B associated with power semiconductor device Q_{B} is a path for a current flowing from gate drive voltage output unit 11-B toward gate line 12-B associated with gate drive voltage output unit 11-B, and is provided between positive gate resistor R_{gBon} and gate line 12-B.

Second wiring route 15-A associated with power semiconductor device Q_{A} is a path for a current flowing from gate line 12-A connected to first wiring route 14-A toward gate drive voltage output unit 11-A associated with gate line 12-A, and is provided between negative gate resistor R_{gAoff} and gate line 12-A.

Second wiring route 15-B associated with power semiconductor device Q_{B} is a path for a current flowing from gate line 12-B connected to first wiring route 14-B toward gate drive voltage output unit 11-B associated with gate line 12-B, and is provided between negative gate resistor R_{gBoff} and gate line 12-B.

Third wiring route 16 attenuates an exciting current generated in magnetic coupling unit 13. Third wiring route 16 is provided to one of two gate lines 12-A and 12-B magnetically coupled together by magnetic coupling unit 13 in parallel with magnetic coupling unit 13. In the example illustrated in Fig. 16, as an example, third wiring route 16 is provided to gate line 12-A in parallel with magnetic coupling unit 13. Third wiring route 16 includes a series circuit including a third resistor R_{S} and a first switch SS that opens/closes to connect/disconnect a wire leading to third resistor R_{S}. Hence, the series circuit is connected to gate line 12-A in parallel with magnetic coupling unit 13.

Subsequently, an operation of gate drive device 1 according to the third embodiment of the present disclosure will be described.

Turning on power semiconductor device Q_{A} is implemented when positive switch SH_{A} and negative switch SL_{A} of gate drive voltage output unit 11-A turn on and off, respectively, and accordingly, a positive gate drive voltage (e.g., 17 V) is output from the positive terminal of gate drive voltage output unit 11-A and applied to the gate terminal of power semiconductor device Q_{A}. When the positive potential of the gate drive voltage output from positive potential output unit VF_{A} of gate drive voltage output unit 11-A is applied to power semiconductor device Q_{A} earlier than power semiconductor device Q_{B} with first switch SS turned off, the gate-source voltage of power semiconductor device Q_{A} starts to increase from negative toward positive in potential. When this is done, a current flows from positive potential output unit VF_{A} via positive switch SH_{A}, positive gate resistor R_{gAon} and magnetic coupling unit 13 to input capacitance Cgs_{A} of power semiconductor device Q_{A}. In order to cause positive switch SH_{A} in gate drive voltage output unit 11-A to switch at as high a speed as possible, positive gate resistor R_{gAon} is set to a small value, and accordingly, a resonant condition may be satisfied, and the current oscillates. Input capacitance Cgs_{A} of power semiconductor device Q_{A} increases in voltage close to the positive potential of the gate drive voltage output from positive potential output unit VF_{A}, and thereafter when first switch SS is turned on, an exciting current causing oscillation of the current flowing through magnetic coupling unit 13 flows through third resistor R_{S}, and the exciting current is thus attenuated rapidly. This suppresses oscillation of the gate-source voltage of power semiconductor device Q_{A}.

An effect of the third embodiment of the present disclosure will now be described through a simulation.

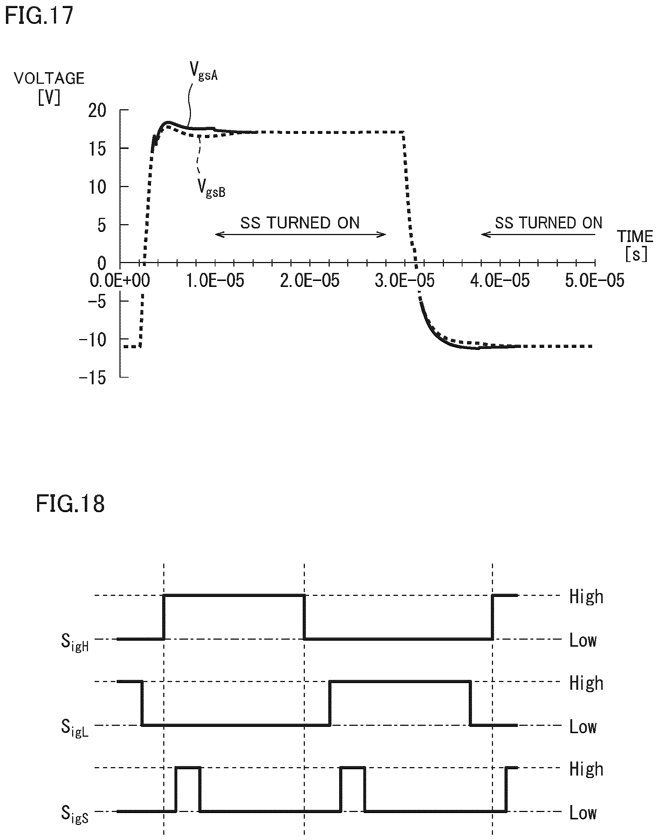

Fig. 17 is a diagram representing a simulation of gate-source voltage in waveform in the gate drive device according to the third embodiment of the present disclosure.

In the simulation, the on signal of the gate signal for power semiconductor device Q_{A} is output 250 ns earlier than the on signal of the gate signal for power semiconductor device Q_{B}. Power semiconductor devices Q_{A} and Q_{B} are SiC-MOSFETs having a withstand voltage of 3.3 kV/750 A, and the simulation is performed while it is assumed that a load current of 325 A flows when a voltage of 1.8 kV is applied. For a load, an inductive load is assumed. In the simulation, positive gate resistors R_{gAon} and R_{gBon} are set to 4.1 Ω, negative gate resistors R_{gAoff} and R_{gBoff} are set to 6.1 Ω, positive potential output units VF_{A} and VF_{B} output gate drive voltage with a positive potential set to 17 V, and negative potential output units VR_{A} and VR_{B} output gate drive voltage with a negative potential set to -11 V. Gate-source voltages V_{gsA} and V_{gsB} come close to positive potentials respectively output from positive potential output units VF_{A} and VF_{B}, or an on signal rises, and thereafter when a period of time of 8 µs elapses, first switch SS is turned on, and thereafter when a period of time of 18 µs elapses, first switch SS is turned off. Further, gate-source voltages V_{gsA} and V_{gsB} come close to negative potentials respectively output from negative potential output units VR_{A} and VR_{B}, or an off signal falls, and thereafter when a period of time of 8 µs elapses, first switch SS is turned on, and thereafter when a period of time of 18 µs elapses, first switch SS is turned off.

As shown in Fig. 17, it can be seen that turning on first switch SS after gate-source voltages V_{gsA} and V_{gsB} of power semiconductor devices Q_{A} and Q_{B} increase rapidly attenuates oscillation of gate-source voltages V_{gsA} and V_{gsB}. It can be seen that after first switch SS is turned on when a period of time of about 4 µs elapses gate-source voltages V_{gsA} and V_{gsB} of power semiconductor devices Q_{A} and Q_{B} have the same value. The third embodiment of the present disclosure can thus suppress oscillation of gate-source voltages V_{gsA} and V_{gsB} of power semiconductor devices Q_{A} and Q_{B} and thus there is no difference caused in gate voltage at a time point when switching starts, and this can avoid an increased unbalance in voltage sharing (or drain-source voltage) for power semiconductor devices Q_{A} and Q_{B}. In the first embodiment of the present disclosure, as has been described with reference to Fig. 14, a period of time of about 25 µs is required before gate-source voltage V_{gsA} of power semiconductor device Q_{A} and gate-source voltage V_{gsB} of power semiconductor device Q_{B} are equal. In contrast, the third embodiment of the present disclosure can significantly reduce it to a period of time of about 12 µs as counted from when turning on or turning off starts. Timing first switch SS to turn on earlier can further reduce the period of time. When the third embodiment of the present disclosure is compared with the first embodiment, the former can set a shorter period of time as a minimum on or off period of time for avoiding switching while gate-source voltages V_{gsA} and V_{gsB} oscillate.

Fig. 18 is a diagram for illustrating how the first switch, the positive switch, and the negative switch operate in the gate drive device according to the third embodiment of the present disclosure.

In the third embodiment of the present disclosure, first switch SS turns on for a first determined period of time of a period of time for which first wiring routes 14-A and 14-B pass a current and first switch SS turns off for a period of time excluding the first determined period of time, and first switch SS turns on for a second determined period of time of a period of time for which second wiring routes 15-A and 15-B pass a current and first switch SS turns off for a period of time excluding the second determined period of time.

First switch SS is turned on/off as controlled in response to a signal S_{igs}, positive switch SH_{A} is turned on/off as controlled in response to a signal S_{igH}, and negative switch SL_{A} is turned on/off as controlled in response to a signal S_{igL}. These signals for controlling the switches are generated by power conversion control unit 3 included in the computing device (or processor) provided in power conversion apparatus 100 shown in Fig. 6. In the example shown in Fig. 18, the switches are turned on in response to signals S_{igs}, S_{igH}, and S_{igL} being high in voltage, and the switches are turned off in response to the signals being low in voltage.

For turning on power semiconductor devices Q_{A} and Q_{B}, signal S_{igH} is pulled high in voltage to turn on positive switches SH_{A} and SH_{B} to pass a current through first wiring routes 14-A and 14-B, and gate-source voltages V_{gsA} and V_{gsB} of power semiconductor devices Q_{A} and Q_{B} increase toward positive voltage. Once the voltages have sufficiently increased, signal S_{igS} is pulled high in voltage to turn on first switch SS for a short period of time to rapidly attenuate oscillation of gate-source voltages V_{gsA} and V_{gsB} of power semiconductor devices Q_{A} and Q_{B} and rising of turning off power semiconductor devices Q_{A} and Q_{B} is completed. After gate-source voltages V_{gsA} and V_{gsB} of power semiconductor devices Q_{A} and Q_{B} no longer oscillate, signal S_{igS} is pulled low in voltage to turn off first switch SS and a shift is made to continuing turning on power semiconductor devices Q_{A} and Q_{B}.

For turning off power semiconductor devices Q_{A} and Q_{B}, signal S_{igH} is pulled low in voltage to turn off positive switches SH_{A} and SH_{B} and subsequently signal S_{igL} is pulled high in voltage to turn on negative switches SL_{A} and SL_{B} to pass a current through second wiring routes 15-A and 15-B, and gate-source voltages V_{gsA} and V_{gsB} of power semiconductor devices Q_{A} and Q_{B} decrease toward negative voltage. Once the voltages have sufficiently decreased, signal S_{igS} is pulled high in voltage to turn on first switch SS for a short period of time to rapidly attenuate oscillation of gate-source voltages V_{gsA} and V_{gsB} of power semiconductor devices Q_{A} and Q_{B} and falling of turning off power semiconductor devices Q_{A} and Q_{B} is completed. After gate-source voltages V_{gsA} and V_{gsB} of power semiconductor devices Q_{A} and Q_{B} no longer oscillate, signal S_{igS} is pulled low in voltage to turn off first switch SS and a shift is made to continuing turning off power semiconductor devices Q_{A} and Q_{B}.

When the third embodiment of the present disclosure is applied to a gate drive device for a plurality of series-connected power semiconductor devices and a power conversion apparatus comprising the same, even with a gate signal transmitted for varying periods of time, or the power semiconductor devices having varying characteristics, etc., it can suppress oscillation of a current flowing through the gate terminal of each power semiconductor device, and hence an unbalance in voltage sharing for each power semiconductor device in a switching operation.

### <Fourth Embodiment>

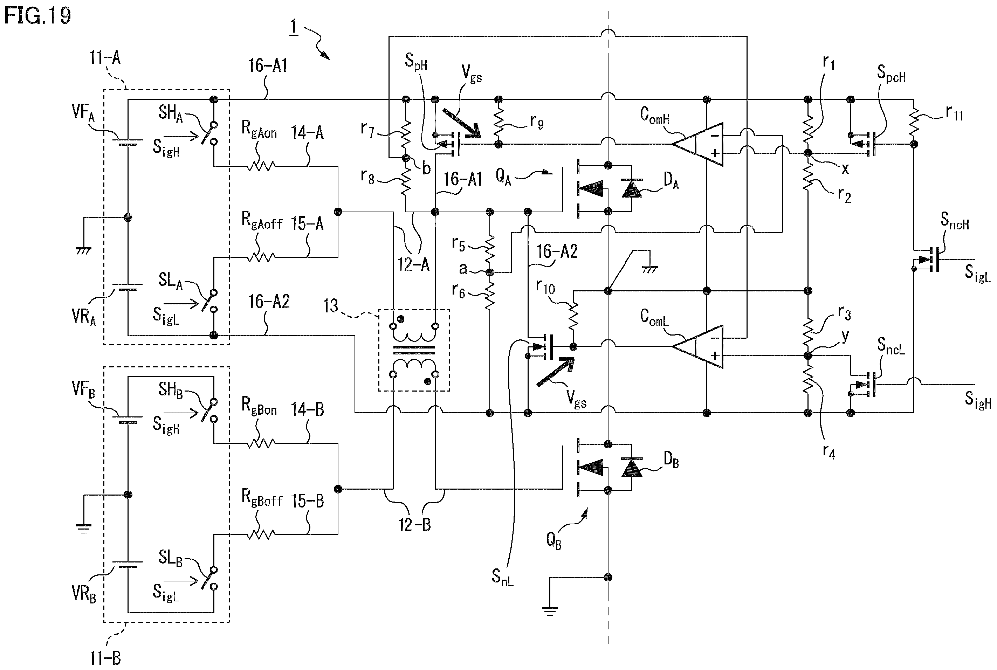

Fig. 19 is a circuit diagram of a gate drive device according to a fourth embodiment of the present disclosure.

The fourth embodiment of the present disclosure is a modification of the third embodiment. The third embodiment of the present disclosure requires a signal line for transmitting signal S_{igS} for controlling first switch SS. An increased number of signal lines leads to a complicated circuit and processing in view of controlling power conversion apparatus 100 configured using gate drive device 1. The fourth embodiment of the present disclosure attempts to implement a circuit configuration that reduces routing of a signal line for each switch.

Gate drive device 1 according to the fourth embodiment of the present disclosure comprises gate drive voltage output units 11-A and 11-B, gate lines 12-A and 12-B, magnetic coupling unit 13, first wiring routes 14-A and 14-B, second wiring routes 15-A and 15-B, and third wiring routes 16-A1 and 16-A2.

Gate drive voltage output units 11-A and 11-B, gate lines 12-A and 12-B, and magnetic coupling unit 13 are as has been described in the first embodiment.

Positive gate resistor R_{gAon} is connected to the positive terminal of gate drive voltage output unit 11-A, and negative gate resistor R_{gAoff} is connected to the negative terminal thereof. Similarly, positive gate resistor R_{gBon} is connected to the positive terminal of gate drive voltage output unit 11-B, and negative gate resistor R_{gBoff} is connected to the negative terminal thereof.

First wiring route 14-A associated with power semiconductor device Q_{A} is a path for a current flowing from gate drive voltage output unit 11-A toward gate line 12-A associated with gate drive voltage output unit 11-A, and is provided between positive gate resistor R_{gAon} and gate line 12-A. Therefore, on first wiring route 14-A are provided positive switch SH_{A} that applies to the gate terminal of power semiconductor device Q_{A} associated with first wiring route 14-A or interrupts a potential on the side of the positive electrode of positive potential output unit VF_{A} of gate drive voltage output unit 11-A, and positive gate resistor R_{gAon} connected to positive switch SH_{A} in series.

First wiring route 14-B associated with power semiconductor device Q_{B} is a path for a current flowing from gate drive voltage output unit 11-B toward gate line 12-B associated with gate drive voltage output unit 11-B, and is provided between positive gate resistor R_{gBon} and gate line 12-B. Therefore, on first wiring route 14-B are provided positive switch SH_{B} that applies to the gate terminal of power semiconductor device Q_{B} associated with first wiring route 14-B or interrupts a potential on the side of the positive electrode of positive potential output unit VF_{B} of gate drive voltage output unit 11-B, and positive gate resistor R_{gBon} connected to positive switch SH_{B} in series.

Second wiring route 15-A associated with power semiconductor device Q_{A} is a path for a current flowing from gate line 12-A connected to first wiring route 14-A toward gate drive voltage output unit 11-A associated with gate line 12-A, and is provided between negative gate resistor R_{gAoff} and gate line 12-A. Therefore, on second wiring route 15-A are provided negative switch SL_{A} that applies to the gate terminal of power semiconductor device Q_{A} associated with second wiring route 15-A or interrupts a potential of 0 volt or less on the side of the negative electrode of negative potential output unit VR_{A} of gate drive voltage output unit 11-A, and negative gate resistor R_{gAoff} connected to negative switch SL_{A} in series.

Second wiring route 15-B associated with power semiconductor device Q_{B} is a path for a current flowing from gate line 12-B connected to first wiring route 14-B toward gate drive voltage output unit 11-B associated with gate line 12-B, and is provided between negative gate resistor R_{gBoff} and gate line 12-B. Therefore, on second wiring route 15-B are provided negative switch SL_{B} that applies to the source terminal of power semiconductor device Q_{B} associated with second wiring route 15-B or interrupts a potential of 0 volt or less on the side of the negative electrode of negative potential output unit VR_{B} of gate drive voltage output unit 11-B, and negative gate resistor R_{gBoff} connected to negative switch SL_{B} in series.

Third wiring routes 16-A1 and 16-A2 associated with power semiconductor device Q_{A} attenuate an exciting current generated in magnetic coupling unit 13.

Third wiring route 16-A1 includes a second switch S_{pH} that opens and closes to connect and disconnect a wire between the gate terminal of power semiconductor device Q_{A} and a connection point between positive switch SH_{A} and the side of the positive electrode of positive potential output unit VF_{A} of gate drive voltage output unit 11-A. Second switch S_{pH} is formed of a p-type MOSFET, and turns on when a negative voltage is applied to its gate terminal with reference to its source terminal.

Third wiring route 16-A2 includes a third switch S_{nL} that opens and closes to connect and disconnect a wire between the gate terminal of power semiconductor device Q_{A} and a connection point between negative switch SL_{A} and the side of the negative electrode of negative potential output unit VR_{A} of gate drive voltage output unit 11-A. Third switch S_{nL} is formed of an n-type MOSFET, and turns on when a positive voltage is applied to its gate terminal with reference to its source terminal.

For turning on power semiconductor devices Q_{A} and Q_{B}, an exciting current generated in magnetic coupling unit 13 is attenuated as it flows through a path through magnetic coupling unit 13, positive gate resistor R_{gAon}, positive switch SH_{A}, and second switch S_{pH}. For turning off power semiconductor devices Q_{A} and Q_{B}, an exciting current generated in magnetic coupling unit 13 is attenuated as it flows through a path through magnetic coupling unit 13, third switch S_{nL}, negative switch SL_{A}, and negative gate resistor R_{gAoff}.

Second switch S_{pH} has its gate terminal connected to its source terminal via a resistance r₉ and also connected to an output terminal of a first comparator C_{omH}. Second switch S_{pH} has its source terminal connected to the side of the positive electrode of positive potential output unit VF_{A}, and has its drain terminal connected to the gate terminal of power semiconductor device Q_{A}. First comparator C_{omH} is, for example, an open collector comparator.

First comparator C_{omH} has an inverting input terminal (or a - terminal) to receive a voltage obtained by dividing a difference in potential between the gate terminal of power semiconductor device Q_{A} and the side of the negative electrode of negative potential output unit VR_{A} by resistances r₅ and r₆. First comparator C_{omH} has a non-inverting input terminal (or a + terminal) to receive a voltage obtained by dividing a difference in potential between the potential on the side of the positive electrode of positive potential output unit VF_{A} and the source terminal of power semiconductor device Q_{A} by resistances r₁ and r₂. Further, to the non-inverting input terminal (or the + terminal) of first comparator C_{omH} is connected a drain terminal of a fourth switch S_{pCH} formed of a p-type MOSFET, and to a source terminal of fourth switch S_{pCH} is connected the side of the positive electrode of positive potential output unit VF_{A}.

Signal S_{igL} is input to a gate terminal of a fifth switch S_{nCH} formed of an n-channel MOSFET. As has been described above, signal S_{igL} is a signal applied to control turning on/off negative switch SL_{A} of gate drive voltage output unit 11-A. To a drain terminal of fifth switch S_{nCH} is connected a gate terminal of fourth switch S_{pCH}. To the source terminal of fourth switch S_{pCH} is connected the gate terminal thereof via a resistance r₁₁. Therefore, fourth switch S_{pCH} is controlled by fifth switch S_{nCH} controlled by signal S_{igL}.

Third switch S_{nL} has its gate terminal connected to the source terminal of power semiconductor device Q_{A} via a resistance r₁₀, and also connected to an output terminal of a second comparator C_{omL}. Third switch S_{nL} has its source terminal connected to the side of the negative electrode of negative potential output unit VR_{A}, and has a drain terminal connected to the gate terminal of power semiconductor device Q_{A}. Second comparator C_{omL} is, for example, an open collector comparator.

Second comparator C_{omL} has an inverting input terminal (or a - terminal) to receive a voltage obtained by dividing a difference in potential between the side of the positive electrode of positive potential output unit VF_{A} and the gate terminal of power semiconductor device Q_{A} by resistances r₇ and r₈. Second comparator C_{omL} has a non-inverting input terminal (or a + terminal) to receive a voltage obtained by dividing a difference in potential between the source terminal of power semiconductor device Q_{A} and the side of the negative electrode of negative potential output unit VR_{A} by resistances r₃ and r₄. Further, to the non-inverting input terminal (or the + terminal) of second comparator C_{omL} is connected a drain terminal of a sixth switch S_{nCL} formed of an n-type MOSFET, and to a source terminal of sixth switch S_{nCL} is connected the side of the negative electrode of negative potential output unit VR_{A}.

Signal S_{igH} is input to a gate terminal of sixth switch S_{nCL}. As has been described above, signal S_{igH} is a signal applied to control turning on/off positive switch SH_{A} of gate drive voltage output unit 11-A.

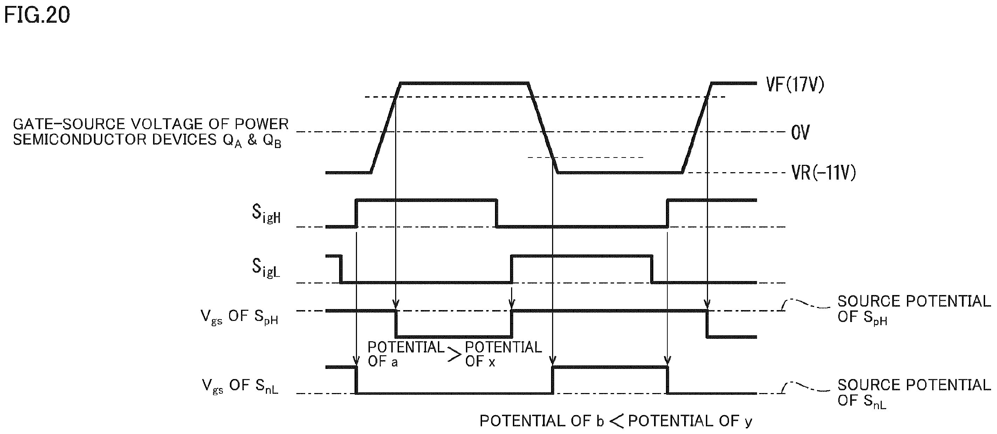

Fig. 20 is a diagram for illustrating how each switch operates in the gate drive device according to the fourth embodiment of the present disclosure.

In the fourth embodiment of the present disclosure, second switch S_{pH} turns on while positive switch SH_{A} turns on, and thereafter, second switch S_{pH} turns off before turning on negative switch SL_{A} starts. Third switch S_{nL} turns on while negative switch SL_{A} turns on, and thereafter, third switch S_{nL} turns off before turning on positive switch SH_{A} starts.

With reference to Fig. 20, second switch S_{pH} is turned on/off as controlled by a signal denoted as V_{gs} of S_{pH}, and third switch S_{nL} is turned on/off as controlled by a signal denoted as V_{gs} of S_{nL}. Positive switch SH_{A} is turned on/off as controlled by signal S_{igH}, and negative switch SL_{A} is turned on/off as controlled by signal S_{igL}. Signals S_{igH} and S_{igL} are generated by power conversion control unit 3 included in the computing device (or the processor) provided in power conversion apparatus 100 shown in Fig. 6.

For turning on power semiconductor devices Q_{A} and Q_{B}, signal S_{igH} is pulled high in voltage and signal S_{igL} is pulled low in voltage to turn on positive switches SH_{A} and SH_{B} and turn off negative switches SL_{A} and SL_{B} to thus pass a current through first wiring routes 14-A and 14-B, and gate-source voltages V_{gsA} and V_{gsB} of power semiconductor devices Q_{A} and Q_{B} increase toward positive voltage. When a connection point a between resistances r₅ and r₆ becomes higher in potential than a connection point x between resistances r₁ and r₂, the output of first comparator C_{omH} and the source terminal of power semiconductor device Q_{A} are short-circuited, and a negative voltage is applied between the gate and source terminals of second switch S_{pH}. As a result, second switch S_{pH} turns on, and an exciting current generated in magnetic coupling unit 13 is attenuated as it flows through a path through magnetic coupling unit 13, positive gate resistor R_{gAon}, positive switch SH_{A}, and second switch S_{pH}.

Subsequently, signal S_{igH} is pulled low in voltage and signal S_{igL} is pulled high in voltage to turn on fifth switch S_{nCH} and turn on fourth switch S_{pCH}, and connection point a between resistances r₅ and r₆ becomes lower in potential than connection point x between resistances r₁ and r₂ and second switch S_{pH} turns off. This operation of fourth switch S_{pCH} can prevent a short circuit caused as negative switch SL_{A} and second switch S_{pH} simultaneously turn on.

For turning off power semiconductor devices Q_{A} and Q_{B}, signal S_{igH} is pulled low in voltage and signal S_{igL} is pulled high in voltage to turn off positive switches SH_{A} and SH_{B} and turn on negative switches SL_{A} and SL_{B} to pass a current through second wiring routes 15-A and 15-B, and gate-source voltages V_{gsA} and V_{gsB} of power semiconductor devices Q_{A} and Q_{B} decrease toward negative voltage. When a connection point b between resistances r₇ and r₈ becomes lower in potential than a connection point y between resistances r₃ and r₄, the short-circuited connection between the output of second comparator C_{omL} and the side of the negative electrode of negative potential output unit VR_{A}, is dissolved, and a positive voltage is applied between the gate and source terminals of third switch S_{nL}. As a result, third switch S_{nL} turns on, and an exciting current generated in magnetic coupling unit 13 is attenuated as it flows through a path through magnetic coupling unit 13, third switch S_{nL}, negative switch SL_{A}, and negative gate resistor R_{gAoff}.

Subsequently, signal S_{igL} is pulled low in voltage and signal S_{igH} is pulled high in voltage to turn on fifth switch S_{nCH}, and connection point b between resistances r₇ and r₈ becomes higher in potential than connection point y between resistances r₃ and r₄, the output of second comparator C_{omL} is connected to the side of the negative electrode of negative potential output unit VR_{A}, and third switch S_{nL} turns off. This operation of sixth switch S_{nCL} can prevent a short circuit caused as positive switch SH_{A} and third switch S_{nL} simultaneously turn on.

Note that a circuit portion internal to each of first comparator C_{omH} and second comparator C_{omL} connected to the output terminal is an open collector circuit. When the inverting input terminal (or the - terminal) receives a voltage higher than the non-inverting input terminal (or the + terminal) does, the output terminal is connected to the negative side of a power supply terminal of the comparator, and when the inverting input terminal (or the - terminal) receives a voltage lower than the non-inverting input terminal (or the + terminal) does, the output terminal is released from the connection to the negative side of the power supply terminal of the comparator.

When the fourth embodiment of the present disclosure is applied to a gate drive device for a plurality of series-connected power semiconductor devices and a power conversion apparatus comprising the same, even with a gate signal transmitted for varying periods of time, or the power semiconductor devices having varying characteristics, etc., it can suppress oscillation of a current flowing through the gate terminal of each power semiconductor device, and hence an unbalance in voltage sharing for each power semiconductor device in a switching operation. In addition, routing a signal line for each switch can be reduced.

While the present disclosure has been described above in detail, the present disclosure is not limited to the individual embodiments described above. Various additions, substitutions, modifications, partial deletions, and the like can be made to these embodiments without departing from the gist of the present disclosure or the gist of the present disclosure derived from the contents described in the claims and their equivalents. For example, in the above-described embodiments, the order of each operation and the order of each processing are indicated as an example, rather than a limitation. Any numerical value or mathematical expression used in the description of the above-described embodiment is similarly discussed.

### REFERENCE SIGNS LIST

1 gate drive device
11-A, 11-B gate drive voltage output unit
12-A, 12-B gate line
13 magnetic coupling unit
14-A, 14-B first wiring route
15-A, 15-B second wiring route
16, 16-A1, 16-A2, 16-B1, 16-B2 third wiring route
21-A, 21-B fourth wiring route
22-A, 22-B fifth wiring route
23-A, 23-B sixth wiring route
30 magnetic body
50 arm
60 leg
100 power conversion apparatus
200 DC power supply
300 load
Cgs_{A}, Cgs_{B} input capacitance of power semiconductor device
C_{omH} first comparator
C_{omL} second comparator
D_{A}, D_{B} feedback diode
D_{Aon}, D_{Bon} first diode, fourth diode
D_{Aoff}, D_{Boff} second diode
Q_{A}, Q_{B} power semiconductor device
R_{Aon}, R_{Bon} first resistor
R_{Aoff}, R_{Boff} second resistor
R_{gAon}, R_{gBon} positive gate resistance
R_{gAoff}, R_{gBoff} negative gate resistance
R_{S} third resistor
r₁, r₂, r₃, r₄, r₅, r₆, r₇, r₈, r₉, r₁₀, r₁₁ resistance
SH_{A}, SH_{B} positive switch
SL_{A}, SL_{B} negative switch
S_{nL} third switch
S_{nCH} fifth switch
S_{pCH} fourth switch
S_{nCL} sixth switch
S_{PH} second switch
SS first switch
T₁, T₂ terminal
VF_{A}, VF_{B} positive potential output unit
VR_{A}, VR_{B} positive potential output unit

## Claims

1. A gate drive device for a plurality of series-connected power semiconductor devices, comprising:
a gate drive voltage output unit provided for each of the power semiconductor devices to output a gate drive voltage;
a gate line provided for each gate drive voltage output unit and connected to a control terminal of the power semiconductor device associated with the gate drive voltage output unit;
a magnetic coupling unit to magnetically couple the gate line and another such gate line together;
a first wiring route serving as a path for a current flowing from the gate drive voltage output unit toward the gate line associated with the gate drive voltage output unit;
a second wiring route serving as a path for a current flowing from the gate line connected to the first wiring route toward the gate drive voltage output unit associated with the gate line; and
a third wiring route to attenuate an exciting current generated in the magnetic coupling unit.

2. The gate drive device according to claim 1, wherein
the first wiring route includes a first diode having an anode connected to a wire leading to a positive terminal of the gate drive voltage output unit and a cathode connected to a wire leading to the magnetic coupling unit, and
the second wiring route includes a second diode having a cathode connected to a wire leading to a negative terminal of the gate drive voltage output unit and an anode connected to a wire leading to the magnetic coupling unit.

3. The gate drive device according to claim 2, wherein the third wiring route includes a first resistor connected to the first diode in parallel and a second resistor connected to the second diode in parallel.

4. The gate drive device according to claim 1, wherein
the third wiring route includes a series circuit including a third resistor and a first switch to open and close to connect and disconnect a wire leading to the third resistor, and
the series circuit is connected to one of the two gate lines that are magnetically coupled together by the magnetic coupling unit such that the series circuit is in parallel with the magnetic coupling unit.

5. The gate drive device according to claim 4, wherein the first switch turns on for a first determined period of time of a period of time for which the first wiring route passes a current and the first switch turns off for a period of time excluding the first determined period of time, and the first switch turns on for a second determined period of time of a period of time for which the second wiring route passes a current and the first switch turns off for a period of time excluding the second determined period of time.

6. The gate drive device according to claim 1, wherein
the first wiring route includes a positive switch to apply to the control terminal of the power semiconductor device associated with the first wiring route or interrupt a potential on a side of a positive electrode of the gate drive voltage output unit, and a positive gate resistance connected to the positive switch in series, and
the second wiring route includes a negative switch to apply to the control terminal of the power semiconductor device associated with the second wiring route or interrupt a potential on a side of a negative electrode of the gate drive voltage output unit, the potential being 0 volt or less, and a negative gate resistance connected to the negative switch in series.

7. The gate drive device according to claim 6, wherein
each gate drive voltage output unit includes a positive potential output unit to output a positive potential of the gate drive voltage, and a negative potential output unit connected to the positive potential output unit in series to output a negative potential of the gate drive voltage, and
the third wiring route includes:
a second switch to open and close to connect and disconnect a wire between the control terminal of the power semiconductor device and a connection point between the positive switch and the side of the positive electrode of the positive potential output unit; and
a third switch to open and close to connect and disconnect a wire between the control terminal of the power semiconductor device and a connection point between the negative switch and the side of the negative electrode of the negative potential output unit.

8. The gate drive device according to claim 7, wherein
the second switch turns on while the positive switch turns on, and thereafter, the second switch turns off before turning on the negative switch starts, and
the third switch turns on while the negative switch turns on, and thereafter, the third switch turns off before turning on the positive switch starts.

9. The gate drive device according to claim 6, wherein the power semiconductor device has a current outflow terminal, which is a source terminal, an emitter terminal, or a cathode terminal.

10. A gate drive device for a plurality of series-connected power semiconductor devices, comprising:
a gate drive voltage output unit provided for each of the power semiconductor devices to output a gate drive voltage;
a gate line provided for each gate drive voltage output unit and connected to a control terminal of the power semiconductor device associated with the gate drive voltage output unit;
a magnetic coupling unit to magnetically couple the gate line and another such gate line together;
a fourth wiring route serving as a path for a current flowing from the gate drive voltage output unit toward the gate line associated with the gate drive voltage output unit;
a fifth wiring route serving as a path for a current flowing from the control terminal of the power semiconductor device to which the gate line is connected toward the gate drive voltage output unit associated with the power semiconductor device; and
a sixth wiring route to attenuate an exciting current generated in the magnetic coupling unit.

11. The gate drive device according to claim 10, wherein
the fourth wiring route includes a fourth diode having an anode connected to a wire leading to a positive terminal of the gate drive voltage output unit and a cathode connected to a wire leading to the magnetic coupling unit, and
the sixth wiring route includes a fourth resistor connected to the fourth diode in parallel.

12. The gate drive device according to any one of claims 1 to 11,
wherein the control terminal of the power semiconductor device is a gate terminal or a base terminal.

13. A power conversion apparatus comprising:
a gate drive device according to any one of claims 1 to 12;
a power conversion circuit unit having an arm provided with the plurality of series-connected power semiconductor devices to perform a power conversion operation in response to the power semiconductor devices turning on/off; and
a power conversion control unit to control the power conversion operation of the power conversion circuit unit.
